# EUROPEAN PATENT APPLICATION

(11) **EP 4 386 115 A1**
(43) Date of publication of application: **19.06.2024**
(21) Application number: 22855734.4
(22) Date of filing: 14.06.2022
(51) Int. Cl.: C30B 15/00, C30B 15/34, C30B 29/06

(54) **THIN PLATE-SHAPED MONOCRYSTAL PRODUCTION DEVICE AND THIN PLATE-SHAPED MONOCRYSTAL PRODUCTION METHOD**

(30) Priority: 11.08.2021 JP 2021131180
(71) Applicant: Crystal Systems Corporation, Hokuto-shi, Yamanashi 408-0044 (JP)
(72) Inventor: SHINDO, Isamu, Hokuto-shi, Yamanashi 408-0041 (JP)
(74) Representative: Michalski Hüttermann & Partner Patentanwälte mbB
(86) International application number: PCT/JP2022/023728
(87) International publication number: WO 2023/017670

(57) **Abstract**

To provide a thin plate-shaped single-crystal production equipment and a thin plate-shaped single-crystal production method capable of applying a large raw material lump while suppressing an increase in output of an infrared ray, and capable of continuously producing a thin plate-shaped single crystal in which a dopant concentration is an optimum composition and uniform at low cost with high accuracy. Included are: an infrared ray irradiation apparatus that irradiates an upper surface of a raw material lump for producing a thin plate-shaped single crystal with an infrared ray to melt a surface of the upper surface of the raw material lump; an elevator apparatus that immerses a lower surface of a thin plate-shaped seed single crystal in a melt melted by the infrared ray irradiation apparatus and obtained on the surface of the upper surface of the raw material lump, and lifts the seed single crystal upward from the immersed state; and a horizontal direction moving apparatus that moves the raw material lump in a horizontal direction. By immersing the lower surface of the seed single crystal in the melt obtained on the surface of the upper surface of the raw material lump by the infrared ray irradiation apparatus via the elevator apparatus, growth of a single crystal is started from the lower surface of the immersed seed single crystal. Furthermore, configured such that, by moving the raw material lump in the horizontal direction by the horizontal direction moving apparatus simultaneously with lifting the seed single crystal upward via the elevator apparatus, a thin plate-shaped single crystal is continuously produced while a molten region of the upper surface of the raw material lump is moved in the horizontal direction.

## Description

### Technical Field

The present invention relates to a thin plate-shaped single-crystal production equipment and a thin plate-shaped single-crystal production method capable of continuously producing a thin plate-shaped single crystal.

### Background Art

A thin plate-shaped single-crystal production equipment and a thin plate-shaped single-crystal production method capable of continuously producing a thin plate-shaped single crystal have already been developed by the present inventor.

The thin plate-shaped single-crystal production equipment and the thin plate-shaped single-crystal production method developed by the present inventor continuously produce a thin plate-shaped single crystal by irradiating an upper surface of a raw material lump for producing a thin plate-shaped single crystal with an infrared ray (laser beam) to melt the upper surface, immersing a thin plate-shaped seed single crystal in the obtained melt, and lifting the thin plate-shaped seed single crystal (Patent Literature 1).

### Citation List

### Patent Literature

Patent Literature 1: Japanese Patent Application No. 2021-002285

### Summary of Invention

### Technical Problem

However, in the thin plate-shaped single-crystal production equipment and thin plate-shaped single-crystal production method described in Patent Literature 1, when an attempt is made to continuously produce a long thin plate-shaped single crystal by enlarging the size of the raw material lump, it is necessary to increase output of the infrared ray (laser beam) in order to melt the upper surface of the enlarged raw material lump, which may lead to an increase in cost of an infrared ray irradiation apparatus and an increase in production cost.

Therefore, an object of the present invention is to provide a thin plate-shaped single-crystal production equipment and a thin plate-shaped single-crystal production method capable of applying a large raw material lump while suppressing an increase in output of an infrared ray, and capable of continuously producing a thin plate-shaped single crystal in which a dopant concentration is an optimum composition and uniform at low cost with high accuracy.

### Solution to Problem

The present invention has been made in order to solve the above-described problems in prior art, and
the thin plate-shaped single-crystal production equipment of the present invention includes:
an infrared ray irradiation apparatus that irradiates an upper surface of a raw material lump for producing a thin plate-shaped single crystal with an infrared ray to melt a surface of the upper surface of the raw material lump;
an elevator apparatus that immerses a lower surface of a thin plate-shaped seed single crystal in a melt melted by the infrared ray irradiation apparatus and obtained on the surface of the upper surface of the raw material lump, and lifts the seed single crystal upward from an immersed state; and
a horizontal direction moving apparatus that moves the raw material lump in a horizontal direction, in which
the thin plate-shaped single-crystal production equipment is configured such that, by immersing the lower surface of the seed single crystal in the melt obtained on the surface of the upper surface of the raw material lump by the infrared ray irradiation apparatus via the elevator apparatus, growth of a single crystal is started from the lower surface of the immersed seed single crystal, and
furthermore, by moving the raw material lump in the horizontal direction by the horizontal direction moving apparatus simultaneously with lifting the seed single crystal upward via the elevator apparatus, a thin plate-shaped single crystal is continuously produced while a molten region of the upper surface of the raw material lump is moved in the horizontal direction.

Furthermore, the thin plate-shaped single-crystal production method of the present invention includes at least:
a melting step of irradiating an upper surface of a raw material lump for producing a thin plate-shaped single crystal with an infrared ray via an infrared ray irradiation apparatus to melt a surface of the upper surface of the raw material lump;
a growing step of immersing a lower surface of a thin plate-shaped seed single crystal via an elevator apparatus in a melt obtained on the surface of the upper surface of the raw material lump in the melting step to start growth of a single crystal from the lower surface of the seed single crystal; and
a continuous production step of continuously producing a thin plate-shaped single crystal while a molten region of the upper surface of the raw material lump is moved in a horizontal direction by moving the raw material lump in the horizontal direction via a horizontal direction moving apparatus simultaneously with lifting the seed single crystal in which growth of the single crystal has been started in the growing step upward.

In this way, since the thin plate-shaped single crystal is grown while the melt (molten region) on the upper surface of the raw material lump is moved in the horizontal direction, the thin plate-shaped single crystal can be stably and continuously grown. In addition, the number of members constituting the thin plate-shaped single-crystal production equipment is small, and a thin plate-shaped single crystal in which a dopant concentration is an optimum composition and uniform can be continuously produced at low cost with high accuracy.

In addition, a raw material lump that is large in a thickness direction and/or in a direction orthogonal to the thickness direction can be used, and a long thin plate-shaped single crystal can be continuously produced. Therefore, a significant reduction in production cost can be achieved.

Furthermore, a thin plate-shaped single crystal having a uniform composition of a so-called incongruent melting substance such as a decomposition melting substance or a solid solution substance can be produced with high accuracy.

In addition, since the raw material lump is moved in the horizontal direction without moving the infrared ray irradiation apparatus, it is not necessary to increase output of the infrared ray irradiation apparatus even when a large raw material lump is applied, and production cost can be suppressed.

In addition, in the thin plate-shaped single-crystal production equipment of the present invention,
the infrared ray emitted from the infrared ray irradiation apparatus is a laser beam.

Furthermore, in the thin plate-shaped single-crystal production method of the present invention,
in the melting step,
the infrared ray emitted from the infrared ray irradiation apparatus is a laser beam.

As described above, with a laser beam, since a predetermined range of the raw material lump can be accurately heated, a melt (molten region) can be reliably and continuously formed on the upper surface of the raw material lump without spilling from the upper surface of the raw material lump.

Note that the infrared ray irradiation apparatus are preferably disposed on four sides that are upper, lower, left, and right sides (for example, every 90 degrees) around the raw material lump in a top view. However, a laser beam emitted from one infrared ray irradiation apparatus may be divided, and the laser beams may be emitted to the raw material lump from four sides.

Furthermore, the number of the infrared ray irradiation apparatus is not limited to four (every 90 degrees), and may be two (every 180 degrees), for example. The number of the infrared ray irradiation apparatus only needs to be determined in consideration of, for example, the size of a hollow quadrangular irradiation region of a laser beam described later or an output intensity of the infrared ray irradiation apparatus.

In addition, in the thin plate-shaped single-crystal production equipment of the present invention,
the irradiation region of the laser beam has a hollow quadrangular shape elongated in a horizontal direction orthogonal to a thickness direction of the raw material lump.

As described above, when the irradiation region of the laser beam has a hollow quadrangular shape, the entire upper surface of the raw material lump can be reliably melted.

In addition, the thin plate-shaped single-crystal production equipment of the present invention includes:
a placing table on which the raw material lump is placed; and
a position control apparatus that performs position control such that the position of the placing table in a vertical direction is a predetermined position.

When the position of the placing table in the vertical direction can be controlled as described above, a raw material lump that is large not only in the horizontal direction but also in the vertical direction can be used. Furthermore, even when a liquid surface position of the melt of the raw material lump is lowered along with lifting of the thin plate-shaped single crystal, the liquid surface position of the melt can be controlled to the same position at all times by raising the position of the raw material lump so as to maintain the initial position.

Therefore, it is only required to fix an infrared ray irradiation position at the same position at all times, and the thin plate-shaped single crystal can be stably and continuously produced with high yield.

Note that when infrared rays (laser beams) traveling in parallel are emitted to the upper surface of the raw material lump from a perpendicular direction, an irradiation intensity of the infrared rays (laser beams) does not change even when the liquid surface position of the melt of the raw material lump is lowered. Therefore, position control of maintaining the liquid surface position of the melt of the raw material lump constant does not have to be performed.

In addition, in the thin plate-shaped single-crystal production equipment of the present invention,
the horizontal direction moving apparatus includes:
a drive shaft disposed on a bottom side of the position control apparatus; and
a driving apparatus that drives the drive shaft, in which
the horizontal direction moving apparatus is configured to move the placing table and the position control apparatus in a horizontal direction which is the thickness direction of the raw material lump by driving the drive shaft via the driving apparatus.

With this configuration, the placing table and the position control apparatus can be reliably moved in the horizontal direction, and growth of the thin plate-shaped single crystal can be stably and continuously performed while the melt (molten region) formed on the upper surface of the raw material lump by irradiation with an infrared ray (laser beam) is moved in the horizontal direction.

In addition, in the thin plate-shaped single-crystal production equipment of the present invention,
in a case where the horizontal direction moving apparatus is configured to
move the placing table and the position control apparatus in a horizontal direction which is the thickness direction of the raw material lump,
positions of both ends of an upper surface of the raw material lump in a horizontal direction orthogonal to the thickness direction of the raw material lump substantially coincide with positions of both ends of the hollow quadrangular shape in the horizontal direction orthogonal to the thickness direction of the raw material lump, and
the size of the irradiation region of the laser beam is set such that a length of the hollow quadrangular shape in the horizontal direction orthogonal to the thickness direction of the raw material lump is slightly smaller than a length of the upper surface of the raw material lump in the horizontal direction orthogonal to the thickness direction of the raw material lump.

In addition, in the thin plate-shaped single-crystal production method of the present invention,
in the continuous production step,
the raw material lump is moved in a horizontal direction which is a thickness direction of the raw material lump via the horizontal direction moving apparatus.

In addition, in the thin plate-shaped single-crystal production method of the present invention,
in the continuous production step,
when the molten region reaches a first end of the upper surface of the raw material lump in the thickness direction of the raw material lump, the molten region is then moved toward a second end in the thickness direction of the raw material lump, which is the opposite side, and this is continuously repeated.

In addition, in the thin plate-shaped single-crystal production method of the present invention,
in the melting step,
an irradiation region of the laser beam has a hollow quadrangular shape elongated in a horizontal direction orthogonal to the thickness direction of the raw material lump,
positions of both ends of an upper surface of the raw material lump in the horizontal direction orthogonal to the thickness direction of the raw material lump substantially coincide with positions of both ends of the hollow quadrangular shape in the horizontal direction orthogonal to the thickness direction of the raw material lump, and
the size of the irradiation region of the laser beam is set such that a length of the hollow quadrangular shape in the horizontal direction orthogonal to the thickness direction of the raw material lump is slightly smaller than a length of the upper surface of the raw material lump in the horizontal direction orthogonal to the thickness direction of the raw material lump.

As described above, when the upper surface of the raw material lump is irradiated with the hollow quadrangular laser beam such that positions of both ends of the upper surface of the raw material lump in a horizontal direction orthogonal to the thickness direction of the raw material lump substantially coincide with positions of both ends of the hollow quadrangular irradiation region of a laser beam in the horizontal direction orthogonal to the thickness direction of the raw material lump, the hollow quadrangular band portion irradiated with the laser beam on the upper surface of the raw material lump is melted first, and a central portion not irradiated with the hollow quadrangular laser beam is melted by thermal conduction from a melt of the quadrangular band portion that has been melted first.

Therefore, the temperature of the central portion not irradiated with the laser beam can be controlled to be lower than the temperature of the quadrangular band portion. Note that as a method for forming the irradiation region of the laser beam in a hollow quadrangular shape, for example, by emitting four linear (rectangular) laser beams from four sides to the upper surface of the raw material lump, a hollow quadrangular shape can be formed.

Furthermore, the laser beam may be emitted to the upper surface of the raw material lump from obliquely above or from directly above in a perpendicular direction, but the laser beam is preferably adjustable to an optimum irradiation angle according to thermal conduction characteristics of a single crystal material and the thickness of a thin plate-shaped single crystal to be produced.

By the way, in order to continuously produce a thin plate-shaped single crystal by melting the raw material lump, it is necessary to simultaneously continue melting of the raw material lump and solidification as a thin plate-shaped single crystal. However, heating is required for melting the raw material lump, and cooling of a melt is required for solidifying the thin plate-shaped single crystal.

Therefore, in order to make stable production of the thin plate-shaped single crystal possible, it is essential to stably continue the contradictory actions of "heating" and "cooling" with good controllability. This can be achieved by irradiating the upper surface of the raw material lump with the laser beam having a hollow quadrangular irradiation region.

That is, by providing the melt (molten region) on the upper surface of the raw material lump with a temperature distribution in which the temperature of the central portion not irradiated with the laser beam is lower than the temperature of the quadrangular band portion, it is possible to stably and continuously grow a thin plate-shaped single crystal from the central portion.

In addition, since the thin plate-shaped single-crystal production equipment of the present invention includes the horizontal direction moving apparatus that moves the raw material lump in the horizontal direction, a first end of the hollow quadrangular irradiation region is caused to substantially coincide with a first end of the upper surface of the raw material lump in the thickness direction, and in this state, the raw material lump is moved in a horizontal direction which is the thickness direction of the raw material lump, whereby a state can be obtained in which it appears that the hollow quadrangular irradiation region is moving toward a second end of the upper surface of the raw material lump in the thickness direction.

As a result, for example, a raw material lump that is large in the thickness direction of the raw material lump can be used, and a long thin plate-shaped single crystal can be continuously produced.

Regarding the size of the raw material lump, when the length of the hollow quadrangular irradiation region of the laser beam in a horizontal direction orthogonal to the thickness direction of the raw material lump "substantially coincides" with the length of the raw material lump in the horizontal direction orthogonal to the thickness direction, there is no limitation on the length of the raw material lump in the thickness direction in principle.

Here, a reason why it is expressed as "substantially coincides" is that if the length of the hollow quadrangular irradiation region of the laser beam in a horizontal direction orthogonal to the thickness direction of the raw material lump completely coincides with the length of the raw material lump in the horizontal direction orthogonal to the thickness direction, that is, if the sizes are made to coincide with each other to the utmost extent, when the upper surface of the raw material lump is melted by irradiation with the laser beam to form a melt (molten region), the melt may spill from the upper surface of the raw material lump.

Therefore, actually, by setting the length of the hollow quadrangular irradiation region of the laser beam in a horizontal direction orthogonal to the thickness direction of the raw material lump to be "slightly smaller" than the length of the raw material lump in the horizontal direction orthogonal to the thickness direction, it is possible to reliably melt from a first end to a second end of the upper surface of the raw material lump in the horizontal direction orthogonal to the thickness direction while the melt is held on the upper surface of the raw material lump by surface tension without spilling from the upper surface of the raw material lump.

Of course, in a case where the raw material lump is moved in the thickness direction of the raw material lump by the horizontal direction moving apparatus, when the position of a first end of the upper surface of the raw material lump in a horizontal direction which is the thickness direction of the raw material lump "substantially coincides" with the position of a first end of the hollow quadrangular irradiation region of the laser beam in the horizontal direction which is the thickness direction of the raw material lump, that is, when both the first ends completely coincide with each other as in the case described above, a melt obtained by irradiation with the laser beam may spill from the upper surface of the raw material lump. Therefore, when a first end of the hollow quadrangular irradiation region of the laser beam in a horizontal direction which is the thickness direction of the raw material lump reaches a position slightly before a first end of the raw material lump in the horizontal direction which is the thickness direction, it is preferable not to further move the raw material lump to the utmost position. The same applies to a second end on the opposite side to the first end.

Note that, since the size of the hollow quadrangular irradiation region of the laser beam and the size of a melt (molten region) formed by irradiation with the laser beam are related to each other, the size of the melt (molten region) increases when output of the laser beam is increased even if the irradiation region has the same size. Therefore, since it is difficult to optimally determine the size of the irradiation region of the laser beam in advance, it is important to first actually irradiate the upper surface of the raw material lump with the laser beam to form a melt (molten region), and to determine the size while observing both output of the laser beam and the size of the hollow quadrangular irradiation region with which the shape of the melt (molten region) does not generate a melt residue and the melt (molten region) does not spill from the upper surface of the raw material lump.

By repeating movement of the molten region in the horizontal direction as described above, it is possible to continuously produce a long thin plate-shaped single crystal using a raw material lump that is large in the horizontal direction.

In addition, in the thin plate-shaped single-crystal production equipment of the present invention,
the horizontal direction moving apparatus includes:
a drive shaft disposed on a bottom side of the position control apparatus; and
a driving apparatus that drives the drive shaft, in which
the horizontal direction moving apparatus is configured to move the placing table and the position control apparatus in a horizontal direction which is a direction orthogonal to the thickness direction of the raw material lump by driving the drive shaft via the driving apparatus.

In addition, in the thin plate-shaped single-crystal production equipment of the present invention,
in a case where the horizontal direction moving apparatus is configured to
move the placing table and the position control apparatus in a horizontal direction which is a direction orthogonal to the thickness direction of the raw material lump,
positions of both ends of an upper surface of the raw material lump in a horizontal direction which is the thickness direction of the raw material lump substantially coincide with positions of both ends of the hollow quadrangular shape in the horizontal direction which is the thickness direction of the raw material lump, and
the size of the irradiation region of the laser beam is set such that a length of the hollow quadrangular shape in the horizontal direction which is the thickness direction of the raw material lump is slightly smaller than a length of the upper surface of the raw material lump in the horizontal direction which is the thickness direction of the raw material lump.

In addition, in the thin plate-shaped single-crystal production method of the present invention,
in the continuous production step,
the raw material lump is moved in a horizontal direction which is a direction orthogonal to the thickness direction of the raw material lump via the horizontal direction moving apparatus.

In addition, in the thin plate-shaped single-crystal production method of the present invention,
in the continuous production step,
when the molten region reaches a first end of the upper surface of the raw material lump in a direction orthogonal to the thickness direction of the raw material lump, the molten region is then moved toward a second end in the direction orthogonal to the thickness direction of the raw material lump, which is the opposite side, and this is continuously repeated.

In addition, in the thin plate-shaped single-crystal production method of the present invention,
in the melting step,
an irradiation region of the laser beam has a hollow quadrangular shape elongated in a horizontal direction orthogonal to the thickness direction of the raw material lump,
positions of both ends of an upper surface of the raw material lump in the thickness direction of the raw material lump substantially coincide with positions of both ends of the hollow quadrangular shape in the thickness direction of the raw material lump, and
the size of the irradiation region of the laser beam is set such that a length of the hollow quadrangular shape in a horizontal direction which is the thickness direction of the raw material lump is slightly smaller than a length of the upper surface of the raw material lump in the horizontal direction which is the thickness direction of the raw material lump.

In this way, even when the raw material lump is moved in a direction orthogonal to the thickness direction of the raw material lump, a long thin plate-shaped single crystal can be continuously produced as described above. Here, it is preferable to use a raw material lump that is large in a direction orthogonal to the thickness direction of the raw material lump.

In addition, in the thin plate-shaped single-crystal production equipment of the present invention,
the horizontal direction moving apparatus includes:
a drive shaft disposed on a bottom side of the position control apparatus; and
a driving apparatus that drives the drive shaft, in which
the horizontal direction moving apparatus is configured to move the placing table and the position control apparatus in a horizontal direction which is the thickness direction of the raw material lump and/or in a horizontal direction which is a direction orthogonal to the thickness direction of the raw material lump by driving the drive shaft via the driving apparatus.

In addition, in the thin plate-shaped single-crystal production method of the present invention,
in the continuous production step,
the raw material lump is moved in a horizontal direction which is the thickness direction of the raw material lump and in a horizontal direction which is a direction orthogonal to the thickness direction of the raw material lump via the horizontal direction moving apparatus.

In addition, in the thin plate-shaped single-crystal production method of the present invention,
in the continuous production step,
when the molten region reaches a first end of the upper surface of the raw material lump in a horizontal direction orthogonal to the thickness direction of the raw material lump, the molten region is moved by a predetermined length in the thickness direction of the raw material lump, and the molten region is then moved toward a second end in the horizontal direction orthogonal to the thickness direction of the raw material lump, which is the opposite side, and
next, the molten region is moved again toward the first end in the horizontal direction orthogonal to the thickness direction of the raw material lump, and this is continuously performed on the entire upper surface of the raw material lump.

In addition, in the thin plate-shaped single-crystal production method of the present invention,
in the melting step,
an irradiation region of the laser beam has a hollow quadrangular shape elongated in a horizontal direction orthogonal to the thickness direction of the raw material lump.

In this way, by moving the raw material lump in the thickness direction of the raw material lump and moving the raw material lump in a direction orthogonal to the thickness direction of the raw material lump, a long thin plate-shaped single crystal can be continuously produced.

In addition, since a raw material lump that is large in both the thickness direction and a direction orthogonal to the thickness direction can be used, a long thin plate-shaped single crystal can be continuously produced.

In addition, in the thin plate-shaped single-crystal production equipment of the present invention,
a moving speed of the placing table and the position control apparatus in the horizontal direction is
within a range of 0.005 mm/min to 100 mm/min.

Furthermore, in the thin plate-shaped single-crystal production method of the present invention,
in the continuous production step,
a moving speed when the raw material lump is moved in the horizontal direction via the horizontal direction moving apparatus is within a range of 0.005 mm/min to 100 mm/min.

In particular, when the moving speed in the horizontal direction is within such a range, by producing a thin plate-shaped single crystal from a molten region formed on the upper surface of the raw material lump, the raw material to be consumed can be supplied from the horizontal direction at all times, and the size and composition of the molten region can be uniformly maintained.

Therefore, a scheme of a "solvent transfer method" can be maintained, and growth of a thin plate-shaped single crystal to be produced can be stably and continuously performed while the composition of the thin plate-shaped single crystal is uniformly maintained.

Note that along with movement of the raw material lump, melting and solidification of the raw material are continued on the upper surface of the raw material lump. The solidification is performed on a portion to be solidified along with production of the thin plate-shaped single crystal and a portion to be solidified along with movement of the molten region along with movement of the raw material lump. In a portion solidified on the upper surface of the raw material lump, when a moving speed of the raw material lump, that is, a moving speed of the molten region is too fast, cell growth may occur.

When cell growth occurs, a lamellar structure is formed in the solidified portion, which makes it difficult to melt the raw material uniformly when the raw material is melted next, which may lead to compositional change in a product. Therefore, the moving speed is preferably within a range in which cell growth does not occur.

Note that when silicon is used as the raw material lump, the moving speed is preferably within a range of 0.5 mm/min to 50 mm/min. Meanwhile, when a material having a low thermal conductivity such as an oxide other than silicon is used as the raw material lump, a lifting (winding) speed of the thin plate-shaped single crystal is slower than that in the case of silicon, and thus the moving speed of the raw material lump is preferably within a range of 0.05 mm/min to 0.5 mm/min.

Furthermore, when a multicomponent oxide material is used as the raw material lump, the lifting (winding) speed of the thin plate-shaped single crystal is further slower than that in the case of using a material having a low thermal conductivity such as an oxide other than silicon, and thus the moving speed of the raw material lump is preferably within a range of 0.005 mm/min to 0.05 mm/min. On the other hand, in a case of a material having a high thermal conductivity such as a metal material, the moving speed of the raw material lump is preferably within a range of 1 mm/min to 100 mm/min.

That is, since an optimum lifting (winding) speed of a thin plate-shaped single crystal varies depending on a material of the raw material lump, it is only required to set the moving speed of the raw material lump according to the material of the raw material lump to be used.

In addition, in the thin plate-shaped single-crystal production equipment of the present invention,
the horizontal direction moving apparatus is
a linear actuator.

As described above, when the horizontal direction moving apparatus is a linear actuator that converts a rotational motion of an electric motor into a linear motion, it is easy to adjust the moving speed when the position control apparatus is moved in the horizontal direction, and vibration is less likely to occur. Therefore, a thin plate-shaped single crystal can be stably and continuously grown without spilling of a melt on the upper surface of the raw material lump from the upper surface.

In addition, in the thin plate-shaped single-crystal production equipment of the present invention,
the elevator apparatus is
a winding apparatus that continuously winds the produced thin plate-shaped single crystal into a roll shape,
the winding apparatus includes:
   a winding shaft that continuously winds the thin plate-shaped single crystal; and
   a rotating apparatus that rotates the winding shaft, and
   the winding apparatus is configured such that the seed single crystal is suspended from the winding shaft via a plurality of thin wires.

When the winding apparatus is configured as described above, the continuously produced thin plate-shaped single crystal can be reliably wound around the winding shaft, and the thin plate-shaped single-crystal production equipment is not made larger than necessary.

In addition, since the produced thin plate-shaped single crystal has a roll shape, the thin plate-shaped single crystal can be easily conveyed at the time of shipment, and handling property thereof can be improved.

Furthermore, when the seed single crystal is suspended with thin wires that are resistant to heat and have high strength, the continuously produced thin plate-shaped single crystal can be reliably wound around the winding shaft.

In addition, in the thin plate-shaped single-crystal production equipment of the present invention,
a winding speed of the thin plate-shaped single crystal by the winding apparatus is
within a range of 0.005 mm/min to 100 mm/min.

When the thin plate-shaped single crystal is wound at such a winding speed, the thin plate-shaped single crystal can be reliably wound without being damaged. Therefore, the thin plate-shaped single crystal can be produced with high yield.

Note that when silicon is used as the raw material lump, the winding speed of the thin plate-shaped single crystal is preferably within a range of 0.5 mm/min to 50 mm/min. Meanwhile, when a material having a low thermal conductivity such as an oxide other than silicon is used as the raw material lump, the lifting (winding) speed of the thin plate-shaped single crystal is slower than that in the case of silicon, and thus the winding speed is preferably within a range of 0.05 mm/min to 0.5 mm/min.

Furthermore, when a multicomponent oxide material is used as the raw material lump, the lifting (winding) speed of the thin plate-shaped single crystal is further slower than that in the case of a material having a low thermal conductivity such as an oxide other than silicon, and thus the winding speed is preferably within a range of 0.005 mm/min to 0.05 mm/min. On the other hand, in a case of a material having a high thermal conductivity such as a metal material, the winding speed is preferably within a range of 1 mm/min to 100 mm/min.

That is, since an optimum lifting (winding) speed of the thin plate-shaped single crystal varies depending on a material of the raw material lump, it is only required to set the winding speed according to the material of the raw material lump to be used.

In addition, in the thin plate-shaped single-crystal production method of the present invention further includes
a winding step of winding the continuously produced thin plate-shaped single crystal into a roll shape
after the continuous production step.

By inclusion of the winding step as described above, the continuously produced thin plate-shaped single crystal can be reliably wound into a roll, and the thin plate-shaped single crystal can be efficiently produced.

In addition, in the thin plate-shaped single-crystal production method of the present invention,
in the winding step,
a winding speed of the thin plate-shaped single crystal is within a range of 0.005 mm/min to 100 mm/min.

When the thin plate-shaped single crystal is wound at such a winding speed, the thin plate-shaped single crystal can be reliably wound without being damaged. Therefore, the thin plate-shaped single crystal can be produced with high yield.

Note that when silicon is used as the raw material lump, the winding speed of the thin plate-shaped single crystal is preferably within a range of 0.5 mm/min to 50 mm/min. Meanwhile, when a material having a low thermal conductivity such as an oxide other than silicon is used as the raw material lump, the lifting (winding) speed of the thin plate-shaped single crystal is slower than that in the case of silicon, and thus the winding speed is preferably within a range of 0.05 mm/min to 0.5 mm/min.

Furthermore, when a multicomponent oxide material is used as the raw material lump, the lifting (winding) speed of the thin plate-shaped single crystal is further slower than that in the case of a material having a low thermal conductivity such as an oxide other than silicon, and thus the winding speed is preferably within a range of 0.005 mm/min to 0.05 mm/min. On the other hand, in a case of a material having a high thermal conductivity such as a metal material, the winding speed is preferably within a range of 1 mm/min to 100 mm/min. That is, since an optimum lifting (winding) speed of the thin plate-shaped single crystal varies depending on a material of the raw material lump, it is only required to set the winding speed according to the material of the raw material lump to be used.

In addition, in the thin plate-shaped single-crystal production equipment of the present invention,
in the seed single crystal,
the thickness of a portion to which the thin wires are attached is
equal to or less than the thickness of the thin plate-shaped single crystal to be produced.

As described above, in the seed single crystal, when the thickness of the portion to which the thin wires are attached is set to be equal to or less than the thickness of the thin plate-shaped single crystal to be produced, it is possible to reliably prevent a surface of the thin plate-shaped single crystal from coming into contact with the thin wires and being damaged when the thin plate-shaped single crystal is wound around the winding shaft.

In addition, in the thin plate-shaped single-crystal production equipment of the present invention,
when a material of the raw material lump is silicon, the thickness of the thin plate-shaped single crystal is within a range of 30 µm to 500 µm.

As described above, in a case where the material of the raw material lump is silicon, when the thin plate-shaped single crystal has such a thickness, the length of the thin plate-shaped single crystal can be made long by continuously producing and winding the high-purity thin plate-shaped single crystal.

Note that when an inclination angle of a laser beam to be emitted to the upper surface of the raw material lump with respect to the horizontal direction and an interval of the laser beams to be emitted are optimally adjusted, it is also possible to produce a thin plate-shaped single crystal thinner than the above thin plate-shaped single crystal or a thin plate-shaped single crystal thicker than the above thin plate-shaped single crystal.

In addition, also when an oxide material or a metal material other than silicon is used as the material of the raw material lump, it is possible to produce a thin plate-shaped single crystal having a desired thickness by optimally adjusting an inclination angle of a laser beam to be emitted to the upper surface of the raw material lump with respect to the horizontal direction and an interval of the laser beams to be emitted.

In addition, in the thin plate-shaped single-crystal production equipment of the present invention,
an auxiliary heating member that heats the raw material lump in advance is disposed around the raw material lump.

When the auxiliary heating member is disposed as described above, an irradiation amount of an infrared ray (laser beam) can be reduced by raising the temperature of the raw material lump to a temperature lower than a melting point thereof in advance. Therefore, even when the size of the raw material lump is increased, it is not necessary to increase output of the infrared ray irradiation apparatus more than necessary, and production cost can be suppressed.

In addition, in the thin plate-shaped single-crystal production equipment of the present invention,
a heat insulating material is further disposed outside the auxiliary heating member.
When the heat insulating material is disposed outside the auxiliary heating member as described above, energy required for heating the raw material lump to a temperature lower than a melting point thereof by the auxiliary heating member can be significantly reduced.

In addition, in the thin plate-shaped single-crystal production equipment of the present invention,
on the upper surface of the raw material lump,
a required amount of a composition of a liquid phase (referred to as a solvent phase) that coexists in equilibrium with the composition of the thin plate-shaped single crystal to be produced is first disposed.

Note that the "required amount" in this case is the same amount as the volume of the molten region formed on the upper surface of the raw material lump by irradiation with a laser beam.

As described above, a required amount of a composition of a liquid phase that coexists in equilibrium with the composition of the thin plate-shaped single crystal to be produced is first disposed on the upper surface of the raw material lump, whereby the scheme of the so-called solvent transfer method can be maintained. Therefore, a uniform thin plate-shaped single crystal having an optimum composition can be continuously produced.

Note that when a component changes due to evaporation from a molten region to be formed, a component in the same amount as the evaporation amount is added to the raw material lump in advance, and a thin plate-shaped single crystal is produced while the composition and the amount do not change at all times, whereby a high-quality thin plate-shaped single crystal having a uniform composition can be produced.

Furthermore, when a predetermined component composition changes due to evaporation, it is also possible to produce a thin plate-shaped single crystal having a predetermined composition by supplying a gas capable of compensating the component by reaction into an atmosphere. For example, when an N-type silicon single crystal containing phosphorus is produced, it is well known to use a phosphine (PH₃) gas.

In addition, in the thin plate-shaped single-crystal production method of the present invention,
in the melting step,
when the thin plate-shaped single crystal to be produced is a decomposition melting substance, a required amount of a composition of a liquid phase (referred to as a solvent phase) that coexists in equilibrium with a composition of the decomposition melting substance is first disposed on the upper surface of the raw material lump.

Further, the thin plate-shaped single-crystal production method of the present invention,
in the melting step,
when the thin plate-shaped single crystal to be produced is a solid solution substance containing a dopant, a required amount of a composition of a liquid phase (referred to as a solvent phase) that coexists in equilibrium with a composition of the solid solution substance is first disposed on the upper surface of the raw material lump.

Note that the "required amount" in this case is the same amount as the volume of the molten region formed on the upper surface of the raw material lump by irradiation with a laser beam.

In a molten region first formed on the upper surface of the raw material lump, supply of a new raw material and solidification from the molten region are continued simultaneously along with movement of the raw material lump. The solidification from the molten region is performed on a portion that solidifies along with production of the thin plate-shaped single crystal and a portion that solidifies along with movement of the molten region.

As a result, since melting and solidification of the raw material lump proceed simultaneously, the dopant concentration in the obtained product (thin plate-shaped single crystal) is the same as the dopant concentration in the raw material lump and is uniform. This scheme is called "solvent transfer method" and is the only means that makes it possible to produce a single crystal product (thin plate-shaped single crystal) having a uniform composition by a "melt method".

As described above, a required amount of a composition of a liquid phase that coexists in equilibrium with a composition of the thin plate-shaped single crystal to be produced is first disposed on the upper surface of the raw material lump, whereby a uniform thin plate-shaped single crystal having an optimum composition can be continuously produced.

Note that when a component changes due to evaporation from a molten region to be formed, a component in the same amount as the evaporation amount is added to the raw material lump in advance, and a thin plate-shaped single crystal is produced while the composition and the amount do not change at all times, whereby a high-quality thin plate-shaped single crystal having a uniform composition can be produced.

### Advantageous Effects of Invention

According to the thin plate-shaped single-crystal production equipment and the thin plate-shaped single-crystal production method of the present invention, by moving a raw material lump in a horizontal direction by a horizontal direction moving apparatus, a thin plate-shaped single crystal is grown while a melt (molten region) on an upper surface of the raw material lump is moved in the horizontal direction. Therefore, a large raw material lump can be applied without an increase in output of an infrared ray, and a thin plate-shaped single crystal in which a dopant concentration is an optimum composition and uniform can be continuously produced at low cost with high accuracy.

In addition, by controlling the position of the molten region formed on the upper surface of the raw material lump to the same position at all times, a raw material lump that is large also in a height direction can be used, and production cost can be significantly reduced.

### Brief Description of Drawings

Fig. 1 is a schematic diagram of a thin plate-shaped single-crystal production equipment according to a first embodiment of the present invention.
Fig. 2 is a diagram illustrating a hollow quadrangular irradiation region formed by four laser beams emitted from four infrared ray irradiation apparatus.
Fig. 3 is a conceptual diagram of a state in which a raw material lump is viewed from an upper side in the thin plate-shaped single-crystal production equipment according to the first embodiment of the present invention.
Fig. 4 is another schematic diagram of the thin plate-shaped single-crystal production equipment according to the first embodiment of the present invention.
Fig. 5 is a diagram for explaining a state of a melt (molten region) formed on an upper surface of a raw material lump in the thin plate-shaped single-crystal production equipment illustrated in Fig. 1.
Fig. 6 is a diagram for explaining a state of a melt (molten region) formed on an upper surface of a raw material lump in the thin plate-shaped single-crystal production equipment illustrated in Fig. 4.
Fig. 7 is a schematic perspective view for explaining states of a raw material lump, a seed single crystal, and a thin plate-shaped single crystal in the first embodiment of the present invention.
Fig. 8 is a diagram for explaining movement of a raw material lump by a horizontal direction moving apparatus in the thin plate-shaped single-crystal production equipment illustrated in Fig. 1.
Fig. 9 is a schematic diagram illustrating a state in which a raw material lump is moved to one side in a thickness direction of the raw material lump by a horizontal direction moving apparatus in the thin plate-shaped single-crystal production equipment illustrated in Fig. 1.
Fig. 10 is a diagram for explaining movement of a raw material lump by a horizontal direction moving apparatus in the thin plate-shaped single-crystal production equipment illustrated in Fig. 1.
Fig. 11 is a schematic diagram illustrating a state in which a raw material lump is moved to the other side in a thickness direction of the raw material lump by a horizontal direction moving apparatus in the thin plate-shaped single-crystal production equipment illustrated in Fig. 1.
Fig. 12 is a schematic diagram of a thin plate-shaped single-crystal production equipment according to a second embodiment of the present invention.
Fig. 13 is a cross-sectional view of a main part of the thin plate-shaped single-crystal production equipment illustrated in Fig. 12.
Fig. 14 is a schematic diagram of a state in which a raw material lump is moved upward by a position control apparatus in the thin plate-shaped single-crystal production equipment according to the second embodiment of the present invention.
Fig. 15 is a schematic diagram of a thin plate-shaped single-crystal production equipment according to a third embodiment of the present invention.
Fig. 16 is a conceptual diagram of a state in which a raw material lump is viewed from an upper side in the thin plate-shaped single-crystal production equipment according to the third embodiment of the present invention.
Fig. 17 is a schematic diagram of a thin plate-shaped single-crystal production equipment according to a fourth embodiment of the present invention.
Fig. 18 is a conceptual diagram of a state in which a raw material lump is viewed from an upper side in the thin plate-shaped single-crystal production equipment according to the fourth embodiment of the present invention.
Fig. 19 is a diagram for explaining movement of a raw material lump by a horizontal direction moving apparatus in the thin plate-shaped single-crystal production equipment according to the fourth embodiment of the present invention illustrated in Fig. 17.
Fig. 20 is a diagram for explaining movement of a raw material lump by a horizontal direction moving apparatus in the thin plate-shaped single-crystal production equipment according to the fourth embodiment of the present invention illustrated in Fig. 17.
Fig. 21 is a conceptual diagram of a state in which a raw material lump is viewed from an upper side in a thin plate-shaped single-crystal production equipment according to a fifth embodiment of the present invention.
Fig. 22 is a schematic perspective view for explaining states of a raw material lump, a seed single crystal, and a thin plate-shaped single crystal in the fifth embodiment of the present invention.
Fig. 23 is a schematic diagram of a thin plate-shaped single-crystal production equipment according to a sixth embodiment of the present invention.
Fig. 24 is a schematic diagram of another thin plate-shaped single-crystal production equipment according to the sixth embodiment of the present invention.
Fig. 25 is a schematic diagram of a thin plate-shaped single-crystal production equipment according to a seventh embodiment of the present invention.
Fig. 26 is an enlarged view of a main part of the thin plate-shaped single-crystal production equipment according to the seventh embodiment of the present invention illustrated in Fig. 25.
Fig. 27 is a schematic diagram illustrating each step of a thin plate-shaped single-crystal production method of the present invention.
Fig. 28 is a schematic diagram illustrating each step of the thin plate-shaped single-crystal production method of the present invention.
Fig. 29 is a schematic diagram illustrating each step of the thin plate-shaped single-crystal production method of the present invention.
Fig. 30 is a schematic diagram of a thin plate-shaped single-crystal production equipment according to another embodiment of the present invention.

### Description of Embodiments

Hereinafter, a thin plate-shaped single-crystal production equipment and a thin plate-shaped single-crystal production method of the present invention will be described in more detail with reference to the drawings.

The thin plate-shaped single-crystal production equipment and the thin plate-shaped single-crystal production method of the present invention are used for making it possible to apply a large raw material lump while suppressing an increase in output of an infrared ray, and continuously producing a thin plate-shaped single crystal in which a composition of a solid solution containing a dopant, for example, is an optimum composition and uniform at low cost with high accuracy.

### <Thin plate-shaped single-crystal production equipment 10>

### [First embodiment]

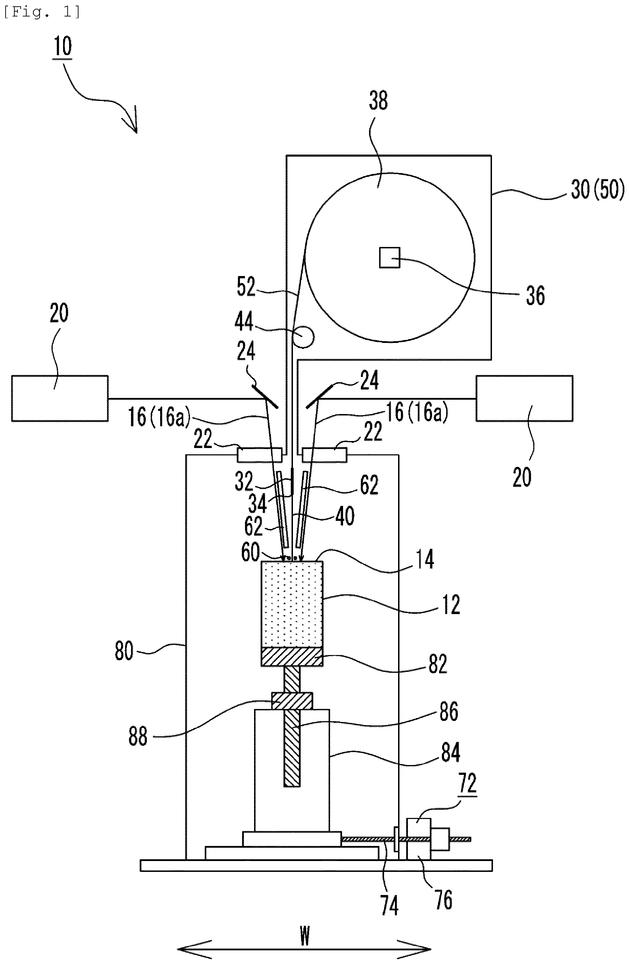

In a thin plate-shaped single-crystal production equipment 10 according to a first embodiment of the present invention, as illustrated in Fig. 1, first, a raw material lump 12 for producing a thin plate-shaped single crystal is placed on a placing table 82 disposed in a chamber 80. The raw material lump 12 has a rectangular parallelepiped shape.

Above the chamber 80, an infrared ray irradiation apparatus 20 for irradiating an upper surface 14 of the rectangular parallelepiped raw material lump 12 with an infrared ray 16 to melt the upper surface 14 to obtain a melt 18 (molten region). Note that, in the drawing, the infrared ray irradiation apparatus 20 are disposed on the left and right of the raw material lump 12. However, actually, the four infrared ray irradiation apparatus 20 are disposed on four peripheral sides that are upper, lower, left, and right sides in a top view of the raw material lump 12 such that the infrared rays 16 are emitted from the four sides to the upper surface 14 of the raw material lump 12 (For convenience of creating Fig. 1, the infrared ray irradiation apparatus 20 disposed in a front-back direction of the raw material lump 12, a reflector 24 described later, and the infrared rays 16 are not illustrated.).

The infrared rays 16 emitted from these four infrared ray irradiation apparatus 20 are preferably laser beams 16a.

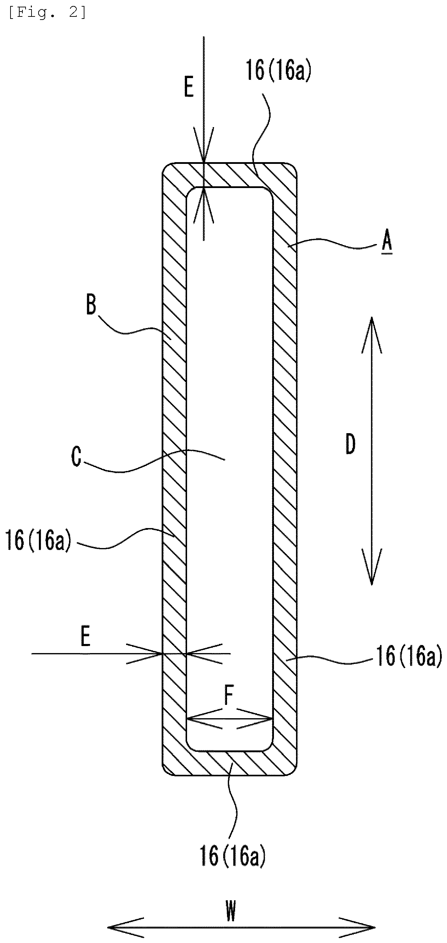

Here, as illustrated in Fig. 2, an irradiation region A of the laser beams 16a has a hollow quadrangular shape elongated in a horizontal direction (vertical direction in Fig. 2), and four sides constituting the quadrangle, that is, two long sides and two short sides are formed by four laser beams 16a having a rectangular cross section, irradiated from the four infrared ray irradiation apparatus 20. Note that a width E of the laser beam 16a is preferably within a range of 3 mm to 6 mm when a thin plate-shaped single crystal 40 having a thickness of about several hundred um is produced.

When the width E of the laser beam 16a is too large, output of the laser beam 16a is increased, which leads to an increase in cost. On the other hand, when the width E of the laser beam 16a is too narrow, it is necessary to increase output of the laser beam 16a in order to form a predetermined molten region 18. When output of the laser beam 16a is increased, the temperature of the melt 18 on the upper surface 14 of the raw material lump 12 irradiated with the laser beam 16a is excessively increased, evaporation tends to be intensified, for example, and it is difficult to stably produce the thin plate-shaped single crystal 40.

Furthermore, a distance F between the laser beam 16a and the laser beam 16a adjacent to each other in a thickness direction W of the raw material lump 12 is preferably within a range of 2 mm to 10 mm.

When the distance F between the laser beam 16a and the laser beam 16a adjacent to each other in the thickness direction W of the raw material lump 12 in the irradiation region A is too narrow, it is difficult to control the temperature of the melt 18 when the thin plate-shaped single crystal 40 is lifted (wound). On the other hand, when the distance F between the laser beam 16a and the laser beam 16a adjacent to each other is excessively large, it is necessary to increase output of the laser beam 16a.

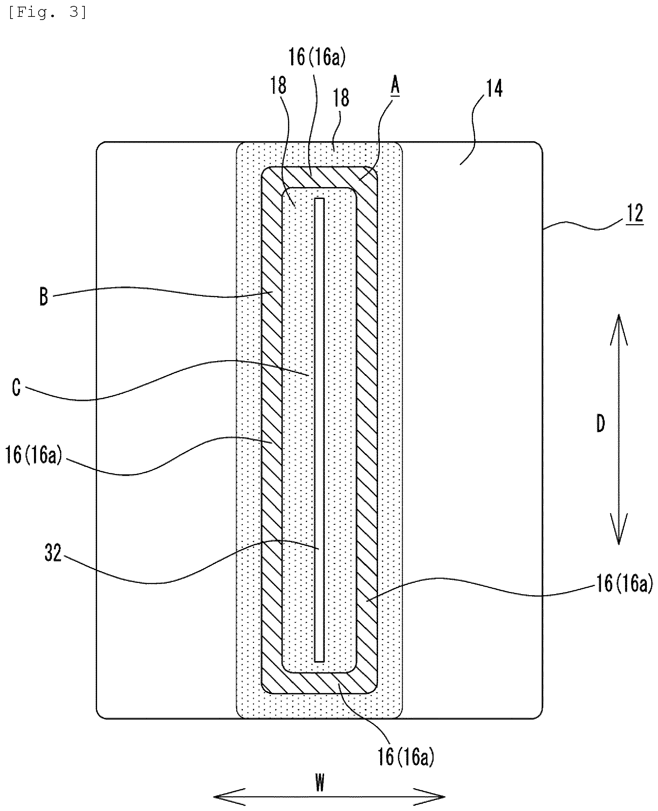

As illustrated in Fig. 3, the laser beam 16a is preferably matched with the hollow quadrangular irradiation region A by the laser beam 16a such that the hollow quadrangular irradiation region A elongated in the horizontal direction is formed on the upper surface 14 of the raw material lump 12.

At this time, in the hollow quadrangular irradiation region A, when the thickness direction of the raw material lump 12 is represented by "W", and a direction (horizontal direction) orthogonal to the thickness direction of the raw material lump 12 is represented by "D", positions of both ends of the upper surface 14 of the raw material lump 12 in the direction (horizontal direction) D orthogonal to the thickness direction of the raw material lump 12 preferably "substantially coincides" with positions of both ends of the hollow quadrangular shape in the direction (horizontal direction) D orthogonal to the thickness direction of the raw material lump 12.

In addition, the size of the irradiation region A of the laser beam 16a is preferably set such that a length of the hollow quadrangular shape in the direction (horizontal direction) D orthogonal to the thickness direction of the raw material lump 12 is slightly smaller than a length of the upper surface 14 of the raw material lump 12 in the direction (horizontal direction) D orthogonal to the thickness direction of the raw material lump 12.

Here, a reason why it is expressed as "substantially coincides" is that if the length of the hollow quadrangular irradiation region A of the laser beam 16a in the direction (horizontal direction) D orthogonal to the thickness direction of the raw material lump 12 completely coincides with the length of the raw material lump 12 in the direction (horizontal direction) D orthogonal to the thickness direction, that is, if the sizes are made to coincide with each other to the utmost extent, when the upper surface 14 of the raw material lump 12 is melted by irradiation with the laser beam 16a to form the melt 18 (molten region), the melt 18 may spill from the upper surface 14 of the raw material lump 12.

Therefore, actually, by setting the length of the hollow quadrangular irradiation region A of the laser beam 16a in the direction (horizontal direction) D orthogonal to the thickness direction of the raw material lump 12 to be "slightly smaller" than the length of the raw material lump 12 in the direction (horizontal direction) D orthogonal to the thickness direction, it is possible to reliably melt from a first end to a second end of the upper surface 14 of the raw material lump 12 in the direction (horizontal direction) D orthogonal to the thickness direction while the melt 18 is held on the upper surface 14 of the raw material lump 12 by surface tension without spilling from the upper surface 14 of the raw material lump 12.

Note that since the size of the hollow quadrangular irradiation region A of the laser beam 16a and the size of the melt 18 (molten region) formed by irradiation with the laser beam 16a are related to each other, the size of the melt 18 (molten region) increases when output of the laser beam 16a is increased even if the irradiation region A has the same size.

Therefore, it is difficult to optimally determine the size of the irradiation region A of the laser beam 16a in advance. Therefore, it is important to first actually irradiate the upper surface 14 of the raw material lump 12 with the laser beam 16a to form the melt 18 (molten region), and to determine the size of the irradiation region A of the laser beam 16a while observing both output of the laser beam 16a and the size of the hollow quadrangular shape formed with the laser beam 16a, the size not generating a melt residue and not making the melt 18 (molten region) spill from the upper surface 14 of the raw material lump 12.

Here, the laser beam 16a emitted from the infrared ray irradiation apparatus 20 may enter the chamber 80 in any way, but preferably, the laser beam 16a enters the chamber 80 from a window 22 disposed in an upper part of the chamber 80 via the reflector 24 and is emitted to the upper surface 14 of the raw material lump 12 in the chamber 80.

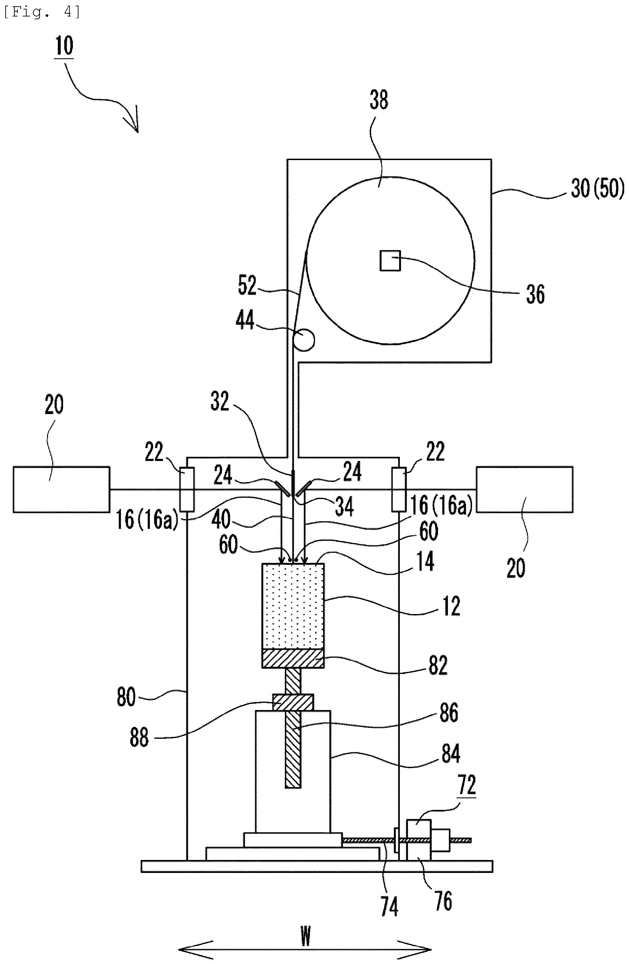

At this time, as illustrated in Fig. 1, the laser beam 16a is emitted to the upper surface 14 of the raw material lump 12 from obliquely above, but as illustrated in Fig. 4, the laser beam 16a may be emitted to the upper surface 14 of the raw material lump 12 from directly above in a perpendicular direction. It is only required to control the laser beam 16a emitted to the upper surface 14 of the raw material lump 12 to an optimum irradiation angle in accordance with, for example, a thermal conductivity of a material of the raw material lump 12 and the thickness of the thin plate-shaped single crystal 40 to be produced.

As a result, when the upper surface 14 of the raw material lump 12 is irradiated with the hollow quadrangular laser beam 16a that is as illustrated in Fig. 2, a portion irradiated with the laser beam 16a (a quadrangular band portion B of the irradiation region A) is melted first as illustrated in Fig. 3, and a central portion C of the hollow quadrangular shape not irradiated with the laser beam 16a is melted by heat conduction from the quadrangular band portion B melted first and from the melt 18 formed in the vicinity of a periphery of the quadrangular band portion B.

Therefore, the temperature of the central portion C not irradiated with the laser beam 16a can be controlled to be lower than the temperature of the portion (quadrangular band portion B) irradiated with the laser beam 16a, and by providing the melt 18 (molten region) on the upper surface 14 of the raw material lump 12 with such a temperature distribution, it is possible to stably and continuously grow the thin plate-shaped single crystal 40 from the central portion of the melt 18 (molten region).

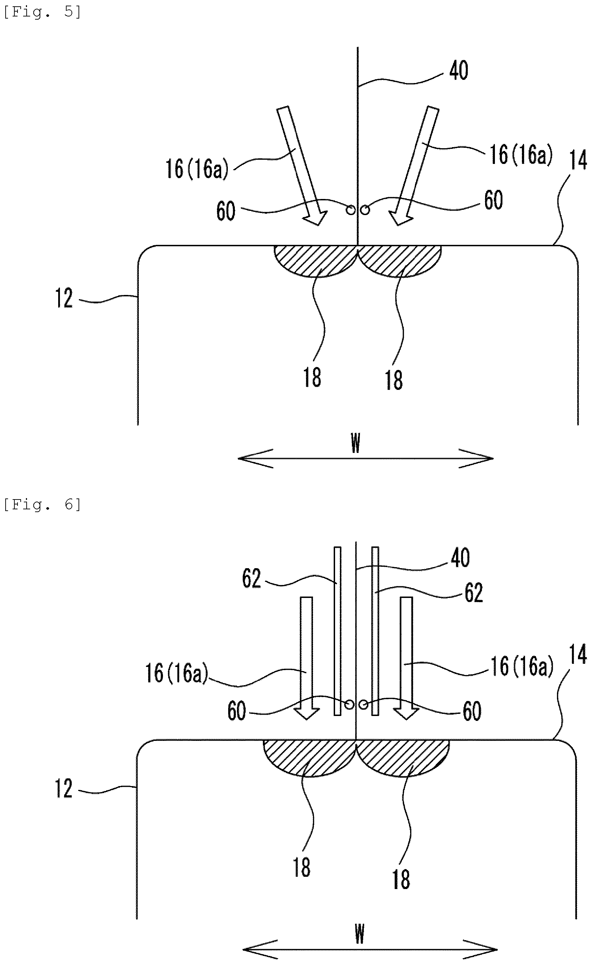

That is, as illustrated in Figs. 5 and 6, by irradiating the upper surface 14 of the raw material lump 12 with the hollow quadrangular laser beam 16a, the melt 18 is formed to a depth deeper than the central portion C in the quadrangular band portion B and the vicinity of the quadrangular band portion B in the hollow quadrangular irradiation region A, and the melt 18 which is shallower and has a lower temperature than the periphery of the central portion C is formed in the central portion C.

Meanwhile, above the chamber 80, an elevator apparatus 30 is disposed which immerses a lower surface 34 of a thin plate-shaped seed single crystal 32 in the melt 18 (molten region) melted by the infrared ray irradiation apparatus 20 and obtained on the upper surface 14 of the raw material lump 12, lifts the seed single crystal 32 upward from the immersed state, and further lifts the thin plate-shaped single crystal 40 produced together with the seed single crystal 32 upward.

The structure of the elevator apparatus 30 is not particularly limited, but for example, the elevator apparatus 30 is preferably a winding apparatus 50 that continuously winds the produced thin plate-shaped single crystal 40 into a roll shape. As a specific configuration, the winding apparatus 50 includes a winding shaft 36 that continuously winds the produced thin plate-shaped single crystal 40 and a rotating apparatus 38 that rotates the winding shaft 36. Note that, in the drawing, a reference numeral 44 denotes a rotating roller serving as a guide when the thin plate-shaped single crystal 40 is continuously wound around the winding shaft 36.

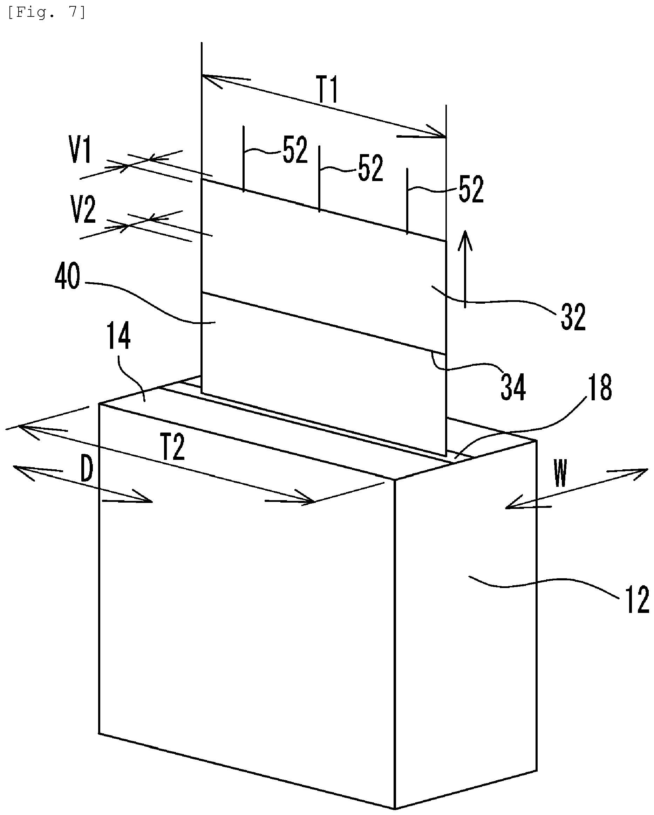

Here, as illustrated in Fig. 7, a size T1 of the lower surface 34 of the seed single crystal 32 in a longitudinal direction (direction D orthogonal to the thickness direction of the raw material lump 12) is set to be slightly smaller than a size T2 of the upper surface 14 of the raw material lump 12 in the direction D orthogonal to the thickness direction of the raw material lump 12. For example, as a specific relationship between these two sizes, the size T2 of the upper surface 14 of the raw material lump 12 in the direction D orthogonal to the thickness direction of the raw material lump 12 is set to be larger than the size T1 of the lower surface 34 of the seed single crystal 32 in a longitudinal direction (direction orthogonal to the thickness direction of the seed single crystal 32) by several mm or more. That is, the sizes are set such that the entire lower surface 34 of the seed single crystal 32 can be immersed in the melt 18.

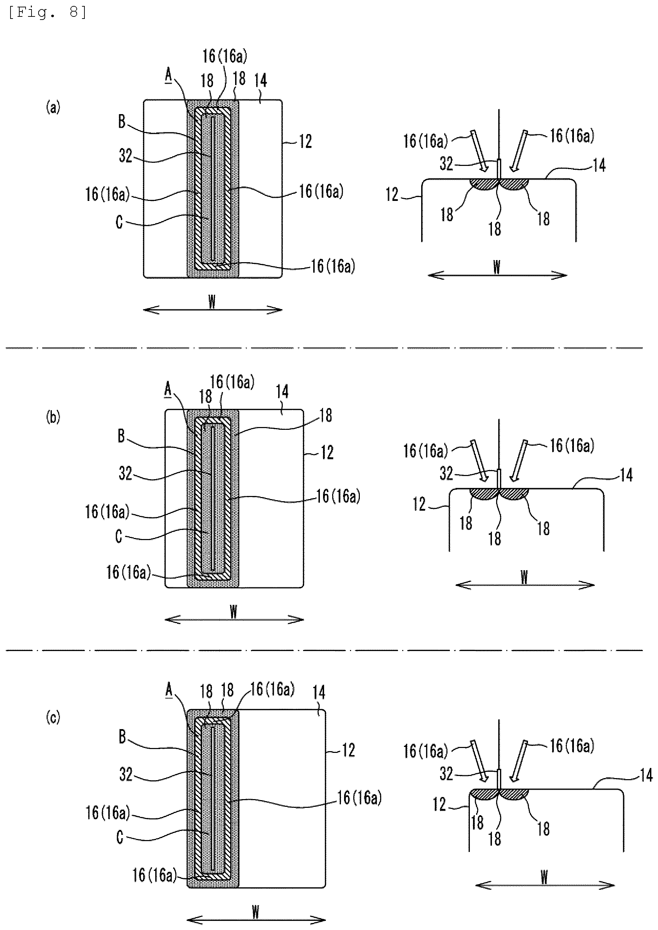

When the raw material lump 12 is moved in the thickness direction W (the right direction in Fig. 8(a)) of the raw material lump 12 via the horizontal direction moving apparatus 72 from the state of Fig. 8(a), the melt 18 (molten region) formed on the upper surface 14 of the raw material lump 12 via the infrared ray irradiation apparatus 20 in which the seed single crystal 32 is immersed moves in the left direction (direction opposite to the moving direction of the raw material lump 12) along with the movement of the raw material lump 12 as illustrated in Fig. 8(b). That is, on a surface of the raw material lump 12, melting proceeds in the moving direction of the melt 18 (molten region), and at the same time, solidification of the melt 18 proceeds in a direction opposite to the moving direction of the melt 18 (molten region).

As illustrated in Fig. 1, the horizontal direction moving apparatus 72 includes a drive shaft 74 disposed on a bottom side of the position control apparatus 84, and a driving apparatus 76 that drives the drive shaft 74, such as a motor. By driving the drive shaft 74 via the driving apparatus 76, the placing table 82 on which the raw material lump 12 is placed and the position control apparatus 84 that performs position control such that a position of the placing table 82 in the vertical direction is a predetermined position can be moved in the thickness direction W of the raw material lump 12.

Note that the position control apparatus 84 drives the drive shaft 86 disposed below the placing table 82 via the driving apparatus 88 such as a motor, and can thereby change a position of the placing table 82 in the vertical direction. However, the present invention is not limited to this structure, and a known means such as an air cylinder may be used.

A moving speed of the placing table 82 and the position control apparatus 84 in the horizontal direction by the horizontal direction moving apparatus 72 is preferably within a range of 0.005 mm/min to 100 mm/min.

Here, when silicon is used as the raw material lump 12, the moving speed is preferably within a range of 0.5 mm/min to 50 mm/min. Meanwhile, when a material having a low thermal conductivity such as an oxide other than silicon is used as the raw material lump 12, the lifting (winding) speed of the thin plate-shaped single crystal 40 is slower than that in the case of silicon, and thus the moving speed of the raw material lump 12 is preferably within a range of 0.05 mm/min to 0.5 mm/min.

Furthermore, when a multicomponent oxide material is used as the raw material lump 12, the lifting (winding) speed of the thin plate-shaped single crystal 40 is further slower than that in the case of a material having a low thermal conductivity such as an oxide other than silicon, and thus the moving speed of the raw material lump 12 is preferably within a range of 0.005 mm/min to 0.05 mm/min. On the other hand, in a case of a material having a high thermal conductivity such as a metal material, the moving speed of the raw material lump 12 is preferably within a range of 1 mm/min to 100 mm/min.

Note that even when the moving speed of the raw material lump 12 is within the above range, it is desirable to lower the moving speed when formation of a lamellar structure due to cell growth is observed at a portion solidified along with the movement of the raw material lump 12 to set the moving speed to a moving speed at which stable melting and solidification of the raw material are possible.

Note that the horizontal direction moving apparatus 72 is preferably a linear actuator that linearly converts a rotational motion of an electric motor. As described above, when the horizontal direction moving apparatus 72 is a linear actuator, it is easy to adjust the moving speed when the position control apparatus 84 is moved in the horizontal direction, and vibration is less likely to occur. Therefore, the thin plate-shaped single crystal 40 can be stably and continuously grown while the melt 18 (molten region) on the upper surface 14 of the raw material lump 12 is held by surface tension without spilling from the upper surface 14.

In addition to the linear actuator, there is no particular limitation as long as the raw material lump 12 can be moved in the horizontal direction without spilling of the melt 18 (molten region) on the upper surface 14 of the raw material lump 12 from the upper surface 14 similarly to the linear actuator, for example, a structure in which the position control apparatus 84 moves in the horizontal direction on a roller conveyor (not illustrated).

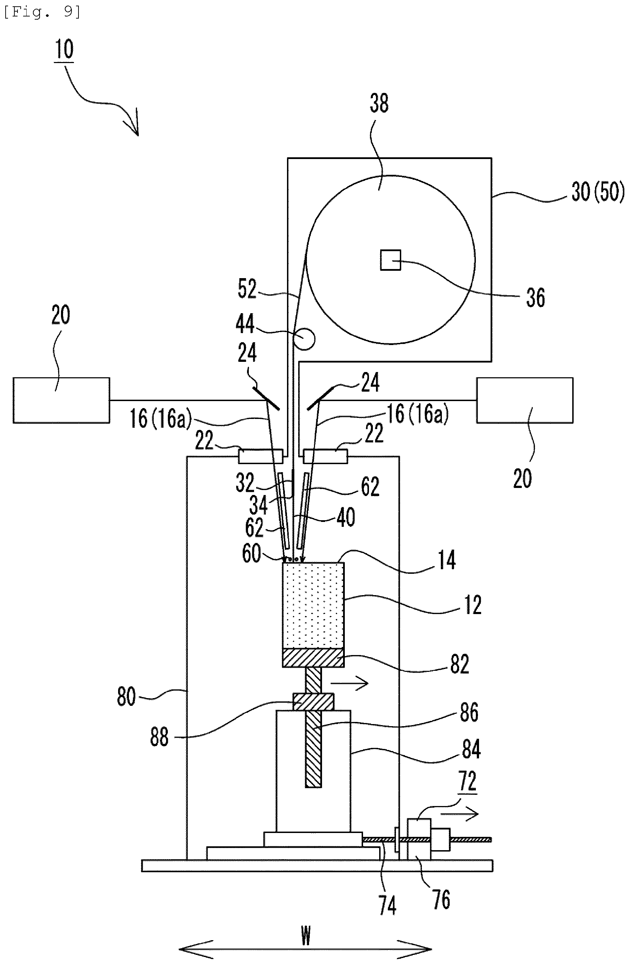

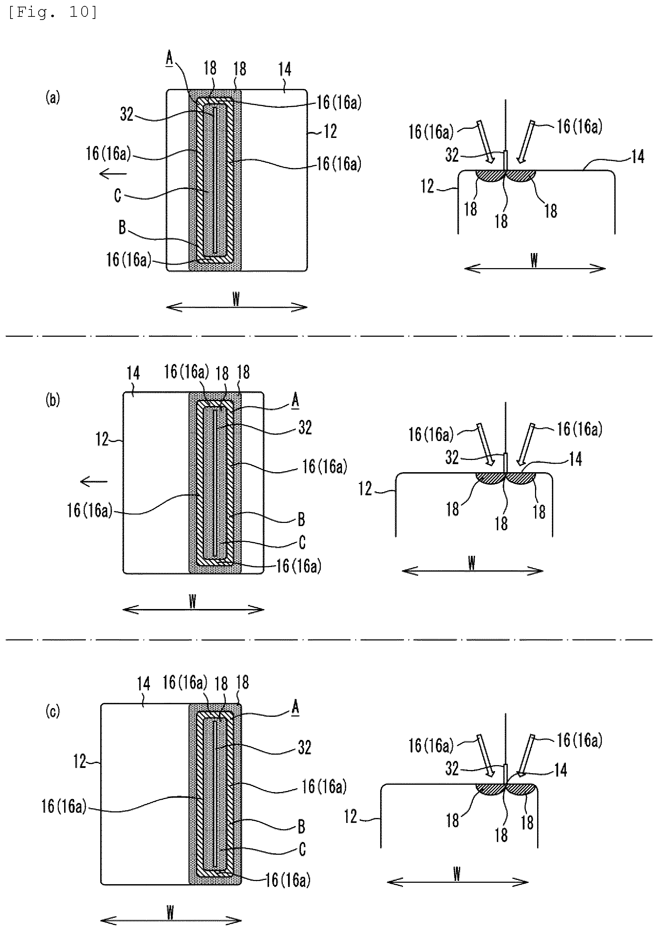

Then, when the melt 18 (molten region) formed by irradiation with the hollow quadrangular laser beam 16a reaches a first end of the raw material lump 12 as illustrated in Figs. 8(c) and 9, the moving direction of the raw material lump 12 is reversed, and the raw material lump 12 is moved in the left direction (direction to a second end of the raw material lump 12) as illustrated in Fig. 10(a).

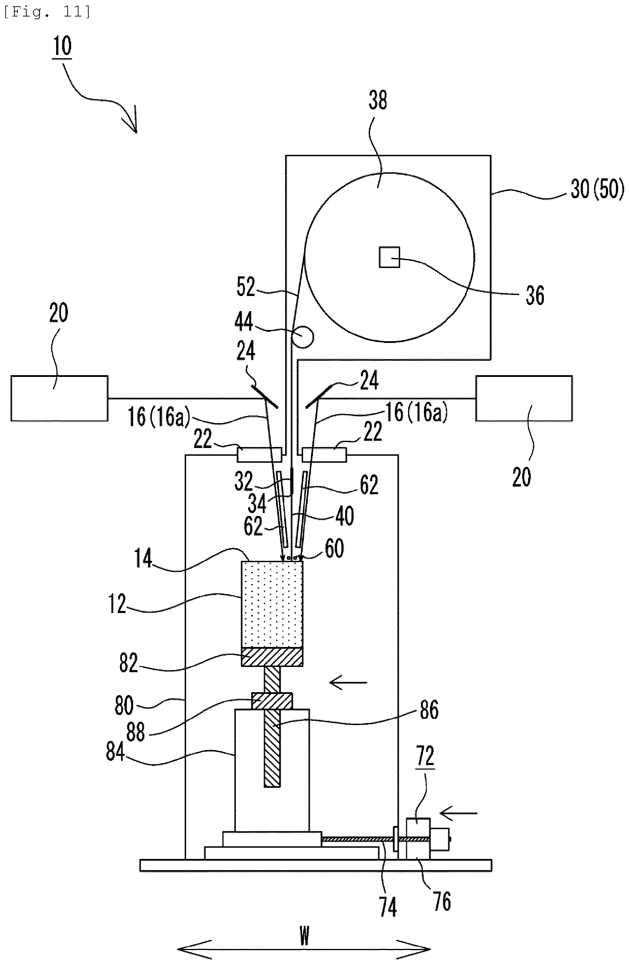

Furthermore, as illustrated in Fig. 10(b), the raw material lump 12 is moved in the left direction (direction to the second end of the raw material lump 12), and when the melt 18 (molten region) reaches the second end of the raw material lump 12 again as illustrated in Figs. 10(c) and 11, the moving direction of the raw material lump 12 is reversed again, and the raw material lump 12 is moved in the right direction (direction to the first end of the raw material lump 12), and the left-right reversal is continuously continued.

As described above, by moving the position of the raw material lump 12 in the left-right horizontal direction (the thickness direction W of the raw material lump 12) via the horizontal direction moving apparatus 72, even when the size of the raw material lump 12 is increased in the thickness direction W of the raw material lump 12, the upper surface 14 of the raw material lump 12 can be sequentially melted and solidified. Therefore, in principle, the raw material lump 12 that is large in the thickness direction can be used without limitation of the size of the raw material lump 12 in the thickness direction W.

Of course, in a case where the raw material lump 12 is moved in the thickness direction W of the raw material lump 12 by the horizontal direction moving apparatus 72, when the position of a first end of the upper surface 14 of the raw material lump 12 in a horizontal direction which is the thickness direction W of the raw material lump 12 "substantially coincides" with the position of a first end of the hollow quadrangular irradiation region A of the laser beam 16a in the horizontal direction which is the thickness direction W of the raw material lump 12, that is, when both the first ends completely coincide with each other as in the case described above, the melt 18 obtained by irradiation with the laser beam 16a may spill from the upper surface 14 of the raw material lump 12.

Therefore, when a first end of the hollow quadrangular irradiation region A of the laser beam 16a in a horizontal direction which is the thickness direction W of the raw material lump 12 reaches a position slightly before a first end of the raw material lump 12 in the horizontal direction which is the thickness direction W, it is preferable not to further move the raw material lump 12 to the utmost position. The same applies to a second end on the opposite side to the first end.

In this way, by immersing the lower surface 34 of the seed single crystal 32 in the central portion of the melt 18 (molten region) continuously obtained while moving on the upper surface 14 of the raw material lump 12 via the elevator apparatus 30 (winding apparatus 50), at an interface of the lower surface 34 of the immersed seed single crystal 32 with the melt 18, heat moves upward of the seed single crystal 32 by heat conduction through the seed single crystal 32, an interface temperature thereby decreases, and growth of a single crystal is started.

In accordance with a growth speed of the single crystal, the seed single crystal 32 is lifted upward via the elevator apparatus 30, and a solid-liquid interface position between the single crystal and the melt 18 is kept constant, whereby the thin plate-shaped single crystal 40 can be stably and continuously produced. Here, a winding speed of the thin plate-shaped single crystal 40 by the winding apparatus 50 is preferably within a range of 0.005 mm/min to 100 mm/min.

Note that when silicon is used as the raw material lump 12, the winding speed of the thin plate-shaped single crystal 40 is preferably within a range of 0.5 mm/min to 50 mm/min. Meanwhile, when a material having a low thermal conductivity such as an oxide other than silicon is used as the raw material lump 12, the lifting (winding) speed of the thin plate-shaped single crystal 40 is slower than that in the case of silicon, and thus the winding speed is preferably within a range of 0.05 mm/min to 0.5 mm/min.

Furthermore, when a multicomponent oxide material is used as the raw material lump 12, the lifting (winding) speed of the thin plate-shaped single crystal 40 is further slower than that in the case of a material having a low thermal conductivity such as an oxide other than silicon, and thus the winding speed is preferably within a range of 0.005 mm/min to 0.05 mm/min. On the other hand, in a case of a material having a high thermal conductivity such as a metal material, the winding speed is preferably within a range of 1 mm/min to 100 mm/min.

That is, since an optimum lifting (winding) speed of the thin plate-shaped single crystal 40 varies depending on a material of the raw material lump 12, it is only required to set the winding speed according to the material of the raw material lump 12 to be used.

The thickness of the thin plate-shaped single crystal 40 to be produced can be adjusted by, for example, the temperature of the melt 18 or the lifting (winding) speed of the seed single crystal 32 in a steady state, and for example, when the material of the raw material lump 12 is silicon, the thickness can be about 30 um to 500 um. Note that when the thickness of the thin plate-shaped single crystal 40 exceeds 500 µm, the winding apparatus 50 is large, and therefore when the thickness exceeds 500 µm, the thin plate-shaped single crystal 40 can be lifted upward without being wound to be formed into a product.

Note that when an inclination angle of the laser beam 16a to be emitted to the upper surface 14 of the raw material lump 12 with respect to the horizontal direction and an interval of the laser beams 16a to be emitted are optimally adjusted, it is also possible to produce the thin plate-shaped single crystal 40 thinner than the above thin plate-shaped single crystal 40 or the thin plate-shaped single crystal 40 thicker than the above thin plate-shaped single crystal 40.

In addition, also when an oxide material or a metal material other than silicon is used as the material of the raw material lump 12, it is possible to produce the thin plate-shaped single crystal 40 having a desired thickness by optimally adjusting an inclination angle of the laser beam 16a to be emitted to the upper surface 14 of the raw material lump 12 with respect to the horizontal direction and an interval of the laser beams 16a to be emitted.

Note that there is a correlation between the temperature of the melt 18 and the lifting (winding) speed of the thin plate-shaped single crystal 40. That is, by decreasing the lifting (winding) speed of the thin plate-shaped single crystal 40 when the temperature of the melt 18 is high because the amount of cooling required for growth of the thin plate-shaped single crystal 40 increases, and increasing the lifting (winding) speed of the thin plate-shaped single crystal 40 when the temperature of the melt 18 is low, productivity of the thin plate-shaped single crystal 40 can be enhanced. Note that when the lifting (winding) speed is too fast, so-called "cell growth" is likely to occur, and crystal characteristics of the thin plate-shaped single crystal 40 are deteriorated. Therefore, the lifting (winding) speed of the thin plate-shaped single crystal 40 is preferably adjusted appropriately.

Note that a thickness V2 of the seed single crystal 32 immersed in the melt 18 and a width (size) in a direction orthogonal to the thickness V2 are not particularly limited, and only need to be appropriately set according to the size of the thin plate-shaped single-crystal production equipment 10.

For example, when the thickness of the seed single crystal 32 is about 300 um to 500 µm, the thin plate-shaped single crystal 40 having a desired thickness can be continuously produced by adjusting the temperature of the melt 18 and the lifting (winding) speed of the thin plate-shaped single crystal 40.

In the present specification, the thickness of the thin plate-shaped single crystal 40 and the thickness of the seed single crystal 32 are illustrated to be different from each other, but this is intentionally made in order to distinguish the thin plate-shaped single crystal 40 and the seed single crystal 32 from each other in the drawings, and a relationship between the thicknesses of the thin plate-shaped single crystal 40 and the seed single crystal 32 is not particularly limited.

When the thin plate-shaped single crystal 40 is wound, it is preferable to suspend the seed single crystal 32 from the winding shaft 36 of the winding apparatus 50 via a plurality of (three in Fig. 7) thin wires 52 which are resistant to heat and have high strength. Particularly, in the seed single crystal 32, when a thickness V1 of a portion to which the thin wires 52 are attached is equal to or less than a thickness V2 of the seed single crystal 32, it is possible to reliably prevent a surface of the thin plate-shaped single crystal 40 from coming into contact with the thin wires 52 and being damaged when the thin plate-shaped single crystal 40 is wound around the winding shaft 36.

A method for attaching the thin wires 52 to the seed single crystal 32 is not particularly limited. However, for example, preferably, several through holes (not illustrated) for tying the thin wires 52 are formed at an end of the seed single crystal 32, and recessed grooves (not illustrated) are formed on both surfaces of the seed single crystal 32 so as to be connected to the through holes such that the thin wires 52 are fitted in the recessed grooves and the thin wires 52 do not protrude outward from the seed single crystal 32 when the thin wires 52 are tied to the seed single crystal 32 In this way, when the thin plate-shaped single crystal 40 is wound, it is possible to reliably prevent a surface of the thin plate-shaped single crystal 40 from coming into contact with the thin wires 52 and being damaged.

In addition, in the thin plate-shaped single-crystal production equipment 10 of the present invention, it is preferable to dispose, between the elevator apparatus 30 and the raw material lump 12, a shake preventing member 60 that prevents the continuously produced thin plate-shaped single crystal 40 from shaking and keeps the thin plate-shaped single crystal 40 within a predetermined range such that a growth position is not shifted, and a shielding member 62 that shields radiant heat emitted from the melt 18 such that the radiant heat does not easily reach the continuously produced thin plate-shaped single crystal 40.

By disposing the shake preventing member 60, it is possible to prevent the produced thin plate-shaped single crystal 40 from being excessively shaken to the left and right to shift a growth position, and it is possible to stably and continuously produce the high-quality thin plate-shaped single crystal 40.

In addition, by disposing the shielding member 62, a production speed of the thin plate-shaped single crystal 40 can be increased. That is, a method for melting the raw material lump 12 and solidifying the raw material lump 12 as a single crystal is called a "melt method", and a growth speed of the single crystal in this melt method is increased by efficiently discharging crystallization latent heat released when the crystal is solidified by heat conduction in the single crystal in contact with the melt 18.

Therefore, for example, when the shielding member 62 is disposed so as not to block an optical path of the infrared ray 16 (laser beam 16a), the amount of radiant heat reaching the thin plate-shaped single crystal 40 can be reduced, and the crystallization latent heat can be efficiently discharged by not raising the temperature of the thin plate-shaped single crystal 40, and efficiency of producing the thin plate-shaped single crystal 40 can be enhanced.

As described above, the thin plate-shaped single crystal 40 can be continuously produced by using the thin plate-shaped single-crystal production equipment 10 of the present invention, but when the thin plate-shaped single crystal 40 is continuously produced, the position of the upper surface 14 of the raw material lump 12 is lowered. In this case, it is necessary to control an irradiation position of the infrared ray 16 (laser beam 16a) by the infrared ray irradiation apparatus 20 to be a desired position.

In the present embodiment, instead of controlling the irradiation position of the infrared ray 16, the placing table 82 on which the raw material lump 12 is placed includes the position control apparatus 84 that controls the position of the placing table 82 in the vertical direction.

By including the position control apparatus 84 as described above, even when the position of the upper surface 14 of the raw material lump 12 is lowered along with lifting of the continuously produced thin plate-shaped single crystal 40, by raising the placing table 82, the position of the upper surface 14 of the raw material lump 12 can be maintained at the same position as the initial position, and a liquid surface position of the melt 18 can be the same position at all times.

Therefore, it is only required to irradiate the same position with the infrared ray 16 at all times, and the thin plate-shaped single crystal 40 can be stably and continuously produced with high yield. Here, in a case where the laser beam 16a is emitted to the upper surface 14 of the raw material lump 12 from directly above the raw material lump 12 perpendicularly as in the thin plate-shaped single-crystal production equipment 10 illustrated in Figs. 4 and 6, the temperature of the melt 18 does not change even when the position of the upper surface 14 of the raw material lump 12 changes in the vertical direction, and thus, position control of the upper surface 14 of the raw material lump 12 in the vertical direction does not have to be performed.

Note that the raw material lump 12 used in the thin plate-shaped single-crystal production equipment 10 described above is the raw material lump 12 having a composition of a material of the thin plate-shaped single crystal 40 to be produced. Note that when the material of the thin plate-shaped single crystal 40 is a decomposition melting substance, even when the raw material lump 12 is melted and solidified as it is using the thin plate-shaped single-crystal production equipment 10 of the present invention, the intended thin plate-shaped single crystal 40 cannot be obtained.

A required amount of a composition of a liquid phase (referred to as a solvent phase) that coexists in equilibrium with the composition of the material of the thin plate-shaped single crystal 40 to be produced is first placed on the upper surface 14 of the raw material lump 12, and first melted. The "required amount" in this case is the same amount as the volume of the melt 18 (molten region) formed on the upper surface 14 of the raw material lump 12 by irradiation with the infrared ray 16 (laser beam 16a). In this way, a solvent corresponding to the amount of the melt phase formed by irradiation with the laser beam 16a is placed on the upper surface 14 of the raw material lump 12.

When the thin plate-shaped single crystal 40 is produced after this, the amount of the raw material newly supplied to the molten region 18 along with movement of the raw material lump 12, the amount of the solidified thin plate-shaped single crystal 40, and the amount of the solidified molten region 18 along with movement of the raw material lump 12 are the same. Therefore, the amount and composition of the solvent do not change from the beginning to the end, and it appears that the solvent phase is solidified and moving while melting the raw material lump 12 and precipitating the single crystal.

This scheme is referred to as "solvent transfer method". When the thin plate-shaped single crystal 40 obtained by the thin plate-shaped single-crystal production equipment 10 of the present invention is a decomposition melting substance or a solid solution substance containing a dopant, it is important to use this "solvent transfer method" in order to make a dopant concentration in the thin plate-shaped single crystal 40 to be obtained uniform.

As described above, according to the present invention, by moving the raw material lump 12 in a horizontal direction by the horizontal direction moving apparatus 72, the thin plate-shaped single crystal 40 is grown while the melt (molten region) 18 on the upper surface 14 of the raw material lump 12 is moved in the horizontal direction. Therefore, the large raw material lump 12 can be applied without increasing output of the infrared ray 16, and the thin plate-shaped single crystal 40 in which a dopant concentration is an optimum composition and uniform can be continuously produced at low cost with high accuracy.

### [Second embodiment]

Next, a thin plate-shaped single-crystal production equipment 10 according to a second embodiment of the present invention will be described.

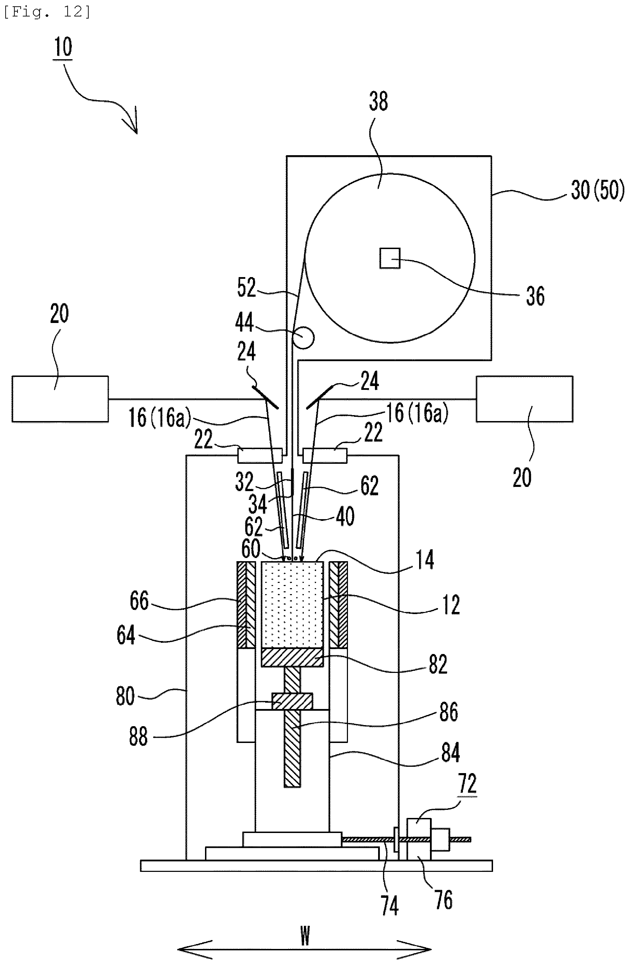

Figs. 12 to 14 illustrate the thin plate-shaped single-crystal production equipment 10 according to the second embodiment of the present invention.

Since the thin plate-shaped single-crystal production equipment 10 illustrated in Figs. 12 to 14 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

As illustrated in Figs. 12 to 14, the thin plate-shaped single-crystal production equipment 10 according to the second embodiment of the present invention is different from the thin plate-shaped single-crystal production equipment 10 according to the first embodiment in that an auxiliary heating member 64 that heats a raw material lump 12 in advance is disposed around the raw material lump 12, and a heat insulating material 66 is disposed outside the auxiliary heating member 64.

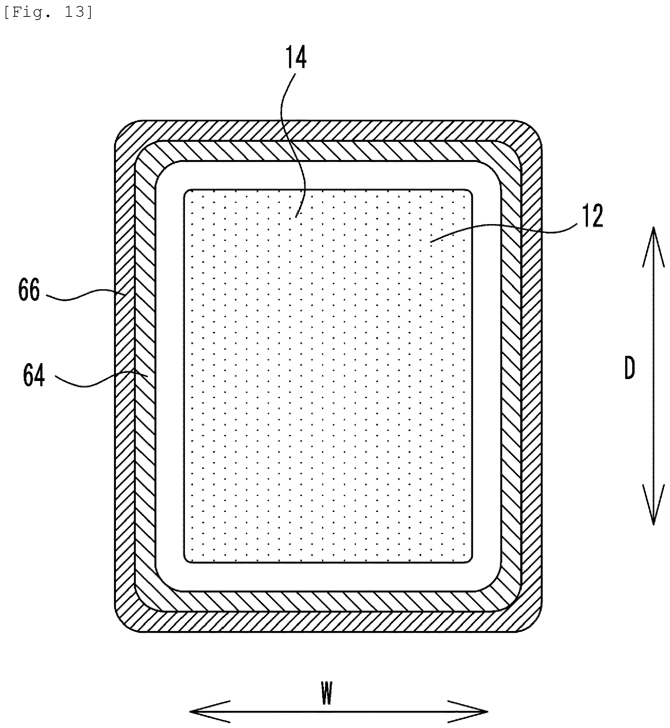

As illustrated in Fig. 13, the auxiliary heating member 64 and the heat insulating material 66 are preferably disposed on a side of a position control apparatus 84 so as to entirely cover the periphery of the raw material lump 12 when the raw material lump 12 is placed on a placing table 82.

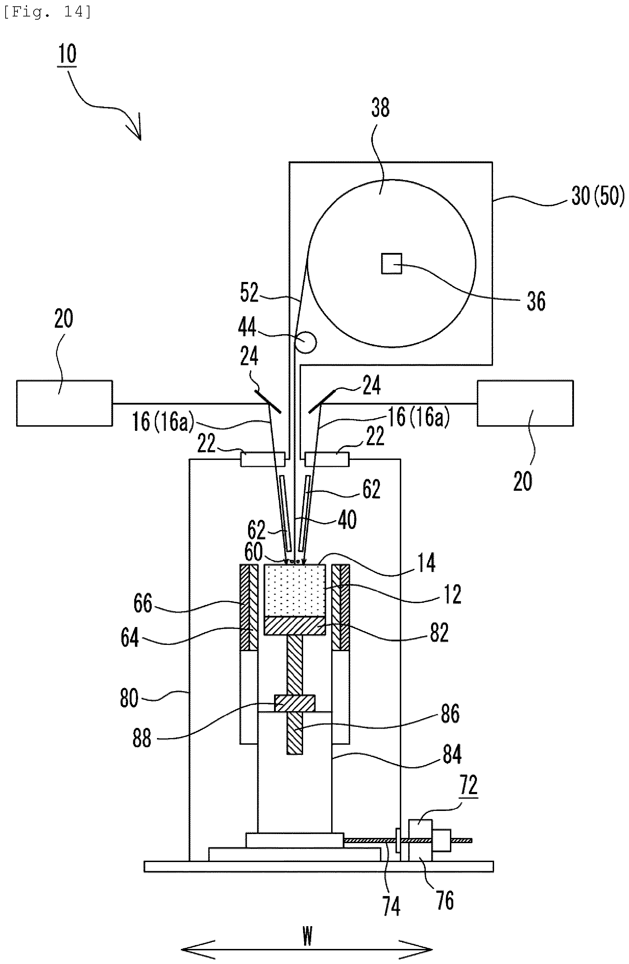

As described above, by disposing the auxiliary heating member 64 and the heat insulating material 66 on a side of the position control apparatus 84, as illustrated in Fig. 14, when the raw material lump 12 is moved upward by the position control apparatus 84 along with melting of an upper surface 14 of the raw material lump 12, the height positions of the auxiliary heating member 64 and the heat insulating material 66 can be maintained at the same position.

In addition, as a matter of course, since the position control apparatus 84 and a horizontal direction moving apparatus 72 are connected to each other, the auxiliary heating member 64 and the heat insulating material 66 can also be moved following movement of the raw material lump 12 in a horizontal direction by the horizontal direction moving apparatus 72, and the raw material lump 12 can be heated at all times.

Note that the raw material lump 12 is heating by the auxiliary heating member 64 preferably to a temperature lower than the melting point of the raw material lump 12.

Before the upper surface 14 of the raw material lump 12 is irradiated with an infrared ray 16 (laser beam 16a) emitted from an infrared ray irradiation apparatus 20, the temperature of the raw material lump 12 is heated to a temperature lower than the melting point in advance via the auxiliary heating member 64, whereby the irradiation amount of the infrared ray 16 (laser beam 16a) can be reduced. Therefore, even when the size of the raw material lump 12 is increased, it is not necessary to increase output of the infrared ray irradiation apparatus 20 more than necessary, and production cost can be suppressed.

In addition, when the heat insulating material 66 is disposed outside the auxiliary heating member 64, energy required for heating the raw material lump 12 to a temperature lower than the melting point by the auxiliary heating member 64 can be saved.

### [Third embodiment]

Next, a thin plate-shaped single-crystal production equipment 10 according to a third embodiment of the present invention will be described.

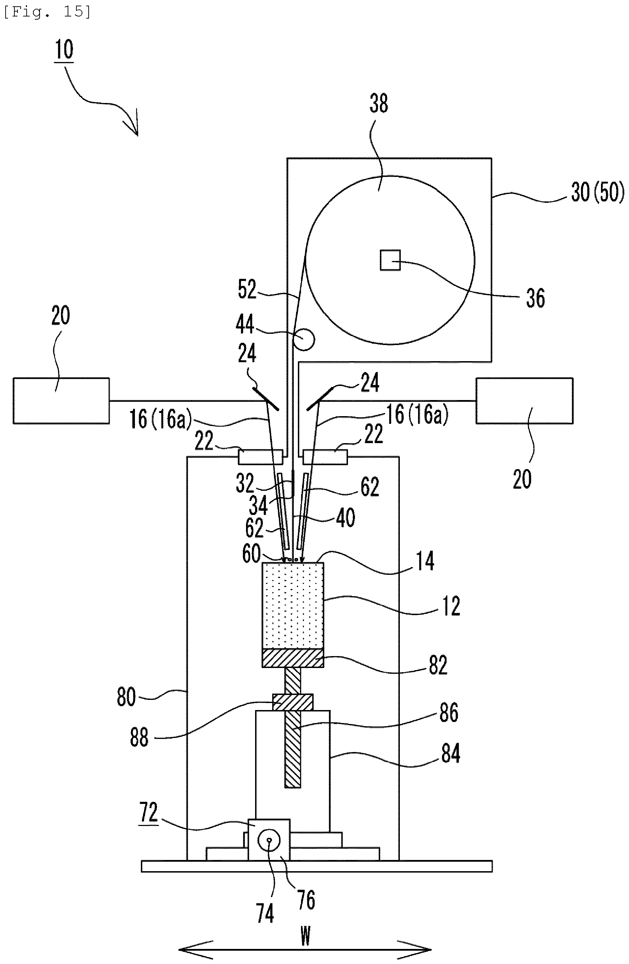

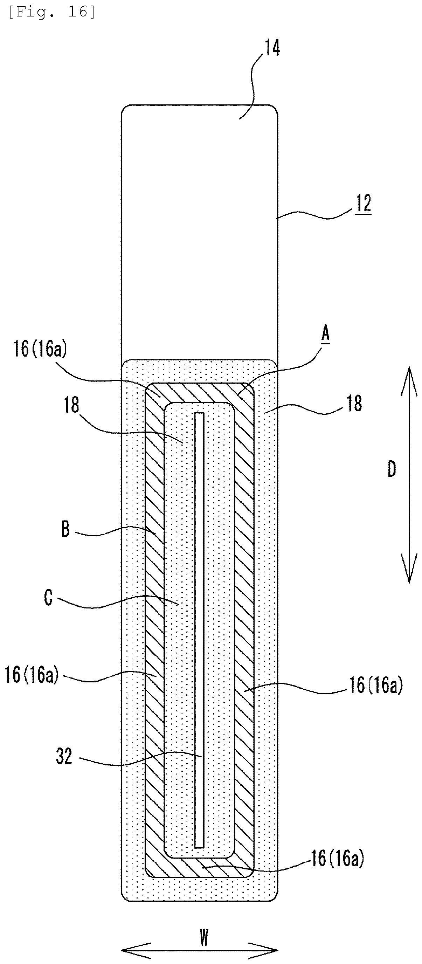

Figs. 15 and 16 illustrate the thin plate-shaped single-crystal production equipment 10 according to the third embodiment of the present invention.

Since the thin plate-shaped single-crystal production equipment 10 illustrated in Figs. 15 and 16 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

As illustrated in Figs. 15 and 16, the thin plate-shaped single-crystal production equipment 10 according to the third embodiment of the present invention is different from the thin plate-shaped single-crystal production equipment 10 according to the first embodiment in that a horizontal direction moving apparatus 72 is disposed on a front side on a bottom side of a position control apparatus 84, and a raw material lump 12 that is large in a direction D orthogonal to a thickness direction of the raw material lump 12 is used.

That is, the thin plate-shaped single-crystal production equipment 10 according to the third embodiment continuously produces a thin plate-shaped single crystal 40 while moving a melt (molten region) 18 disposed on an upper surface 14 of the raw material lump 12 in the direction D (the vertical direction of the arrow in Fig. 16) orthogonal to the thickness direction of the raw material lump 12 by moving the raw material lump 12 in the direction (horizontal direction) D orthogonal to the thickness direction of the raw material lump 12 via the horizontal direction moving apparatus 72.

Here, as illustrated in Fig. 16, a laser beam 16a to be emitted to the upper surface 14 of the raw material lump 12 is preferably matched with a hollow quadrangular irradiation region A by the laser beam 16a such that the hollow quadrangular irradiation region A elongated in the horizontal direction (vertical direction in Fig. 16) is formed on the upper surface 14 of the raw material lump 12 that is large in the direction D orthogonal to the thickness direction of the raw material lump 12.

At this time, in the hollow quadrangular irradiation region A, positions of both ends of the upper surface 14 of the raw material lump 12 in a thickness direction W of the raw material lump 12 preferably "substantially coincides" with positions of both ends of the hollow quadrangular shape in the thickness direction W of the raw material lump 12.

In addition, the size of the irradiation region of the laser beam 16a is preferably set such that a length of the hollow quadrangular shape in the thickness direction W of the raw material lump 12 is slightly smaller than a length of the upper surface 14 of the raw material lump 12 in the thickness direction W of the raw material lump 12.

Here, a reason why it is expressed as "substantially coincides" is, as described in the first embodiment, that if the length of the hollow quadrangular irradiation region A of the laser beam 16a in the thickness direction W of the raw material lump 12 completely coincides with the length of the raw material lump 12 in the thickness direction W, that is, if the sizes are made to coincide with each other to the utmost extent, when the upper surface 14 of the raw material lump 12 is melted by irradiation with the laser beam 16a to form a melt 18 (molten region), the melt 18 may spill from the upper surface 14 of the raw material lump 12.

Therefore, actually, by setting the length of the hollow quadrangular irradiation region A of the laser beam 16a in the thickness direction W of the raw material lump 12 to be "slightly smaller" than the length of the raw material lump 12 in the thickness direction W, it is possible to reliably melt from a first end to a second end of the upper surface 14 of the raw material lump 12 in the direction D orthogonal to the thickness direction while the melt 18 is held on the upper surface 14 of the raw material lump 12 by surface tension without spilling from the upper surface 14 of the raw material lump 12.

After the upper surface 14 of the raw material lump 12 is irradiated with the laser beam 16a to form the melt (molten region) 18, the raw material lump 12 is moved in the direction D (downward direction in Fig. 16) orthogonal to the thickness direction of the raw material lump 12 via the horizontal direction moving apparatus 72, and the melt (molten region) 18 is formed up to a first end of the raw material lump 12 in the direction D orthogonal to the thickness direction of the raw material lump 12. It is only required to repeat this.

As described above, even when the raw material lump 12 is the raw material lump 12 that is large in the direction D orthogonal to the thickness direction of the raw material lump 12, by disposing the horizontal direction moving apparatus 72 on a front side on a bottom side of the position control apparatus 84, the thin plate-shaped single crystal 40 in which a dopant concentration is an optimum composition and uniform can be continuously produced at low cost with high accuracy.

### [Fourth embodiment]

Next, a thin plate-shaped single-crystal production equipment 10 according to a fourth embodiment of the present invention will be described.

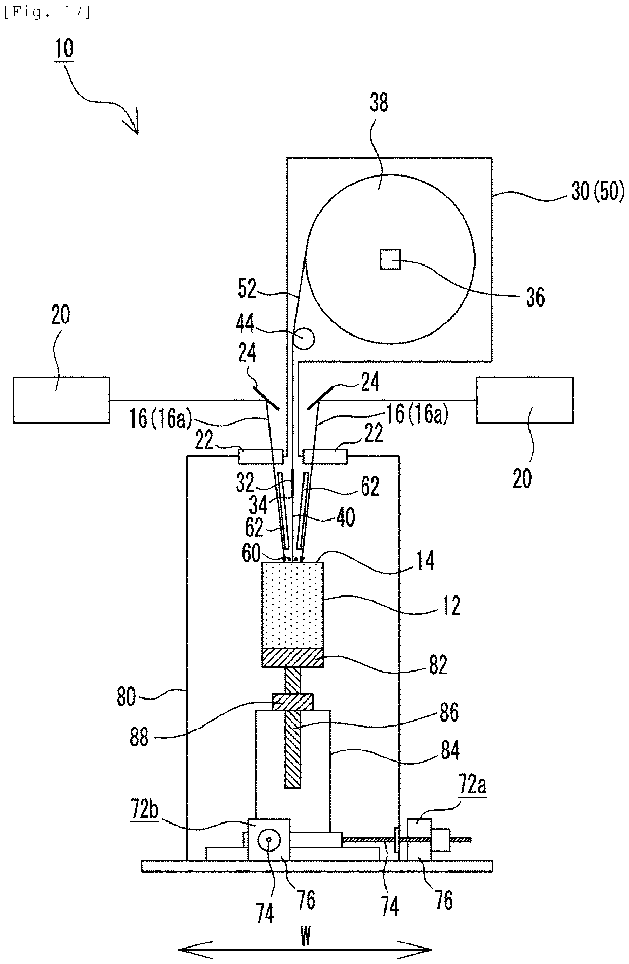

Figs. 17 to 20 illustrate the thin plate-shaped single-crystal production equipment 10 according to the fourth embodiment of the present invention.

Since the thin plate-shaped single-crystal production equipment 10 illustrated in Figs. 17 to 20 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

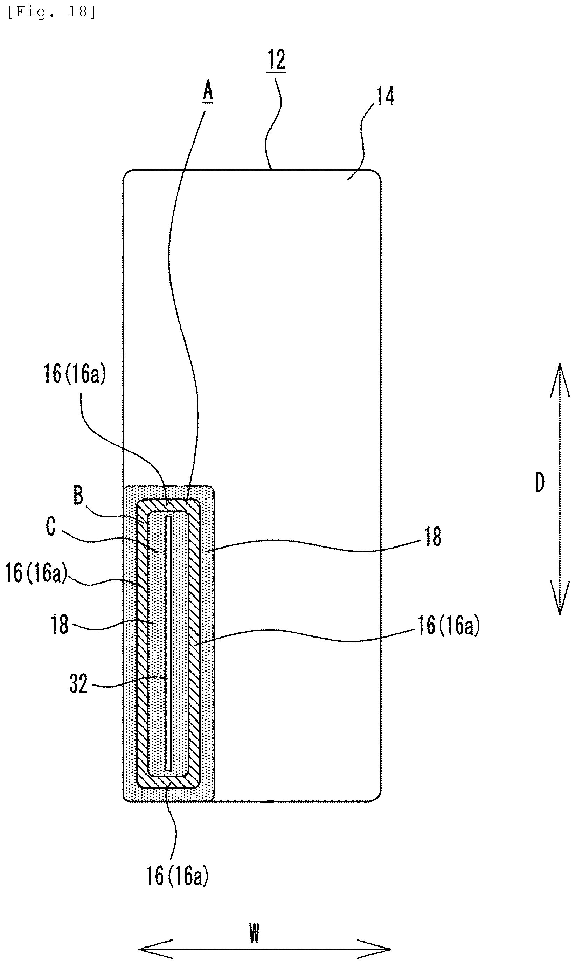

As illustrated in Figs. 17 and 18, the thin plate-shaped single-crystal production equipment 10 according to the fourth embodiment of the present invention is different from the thin plate-shaped single-crystal production equipment 10 according to the first embodiment in that horizontal direction moving apparatus 72 are disposed on a left/right side (right side in Fig. 17) on a bottom side of a position control apparatus 84 and also on a front side on the bottom side of the position control apparatus 84, and a raw material lump 12 that is large both in a thickness direction W of the raw material lump 12 and a direction D orthogonal to the thickness direction is used.

When the two horizontal direction moving apparatus 72 are disposed as described above, the raw material lump 12 can be freely moved in a desired direction in a horizontal direction, and therefore the large raw material lump 12 can be used.

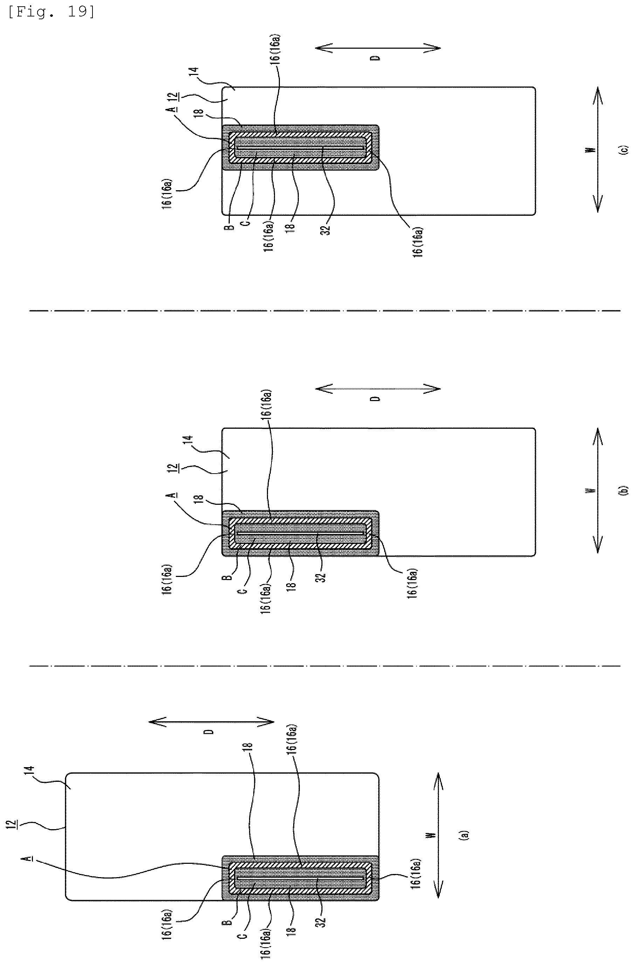

Note that, in a case where the two horizontal direction moving apparatus 72 are disposed as described above, as illustrated in Fig. 18, the raw material lump 12 that is large both in the thickness direction W of the raw material lump 12 and the direction D orthogonal to the thickness direction can be used. For example, as illustrated in Fig. 19(a), first, an irradiation region A of a laser beam 16a is adjusted to the vicinity of a lower left corner of the raw material lump 12 to form a melt (molten region) 18 on an upper surface 14 of the raw material lump 12, and from this position, the raw material lump 12 is moved from a first end toward a second end in the direction D orthogonal to the thickness direction of the raw material lump 12 by a horizontal direction moving apparatus 72b disposed on a front side on a bottom side of the position control apparatus 84, whereby the state illustrated in Fig. 19(b) is obtained.

Next, the raw material lump 12 is moved in the thickness direction W of the raw material lump 12 by a horizontal direction moving apparatus 72a disposed on a left/right side (right side in Fig. 17) on a bottom side of the position control apparatus 84, whereby the state illustrated in Fig. 19(c) is obtained. A moving distance of the raw material lump 12 at this time is a value smaller than the size of the molten region 18 formed by the irradiation region A by the laser beam 16a in the thickness direction, and a moving speed thereof is a speed within a range in which cell growth does not occur when the molten region 18 is solidified along with the movement. A specific moving amount and moving speed of the raw material lump 12 are determined according to production conditions of the thin plate-shaped single crystal 40.

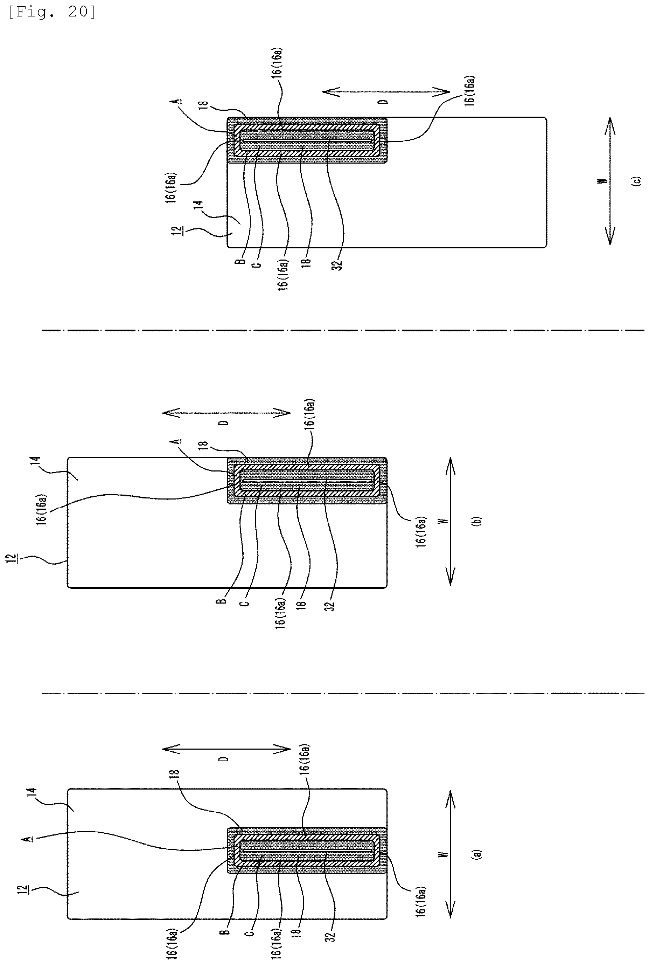

Next, as illustrated in Fig. 20(a), the raw material lump 12 is moved toward the second end in the direction D orthogonal to the thickness direction of the raw material lump 12 again by the horizontal direction moving apparatus 72b disposed on a front side on a bottom side of the position control apparatus 84. When the molten region 18 reaches the second end, as illustrated in Fig. 20(b), the raw material lump 12 is further moved by a predetermined length in the thickness direction W of the raw material lump 12 by the horizontal direction moving apparatus 72a disposed on a left/right side (right side in Fig. 17) on a bottom side of the position control apparatus 84.

Next, as illustrated in Fig. 20(c), by moving the raw material lump 12 toward the first end from the second end in the direction D orthogonal to the thickness direction of the raw material lump 12 by the horizontal direction moving apparatus 72b disposed on a front side on a bottom side of the position control apparatus 84, the entire region of the upper surface 14 of the raw material lump 12 can be melted.

By repeatedly performing such movement according to the size of the upper surface 14 of the raw material lump 12, the thin plate-shaped single crystal 40 can be continuously produced while the molten region 18 formed on the upper surface 14 of the raw material lump 12 is moved in the horizontal direction with respect to the raw material lump 12 that is large both in the thickness direction W of the raw material lump 12 and the direction D orthogonal to the thickness direction. Therefore, the thin plate-shaped single crystal 40 can be continuously produced.

Note that, in the fourth embodiment, by inclusion of the two apparatuses of the horizontal direction moving apparatus 72a and the horizontal direction moving apparatus 72b, the raw material lump 12 can be moved in any direction in the horizontal direction. However, the present invention is not limited to this configuration, and a known horizontal moving table may be used, for example.

### [Fifth embodiment]

Next, a thin plate-shaped single-crystal production equipment 10 according to a fifth embodiment of the present invention will be described.

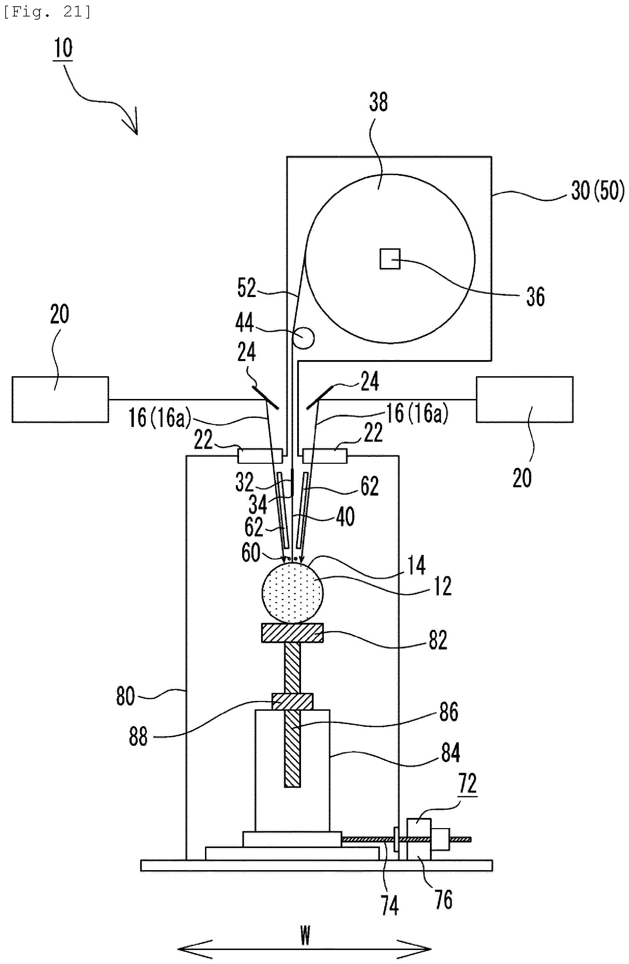

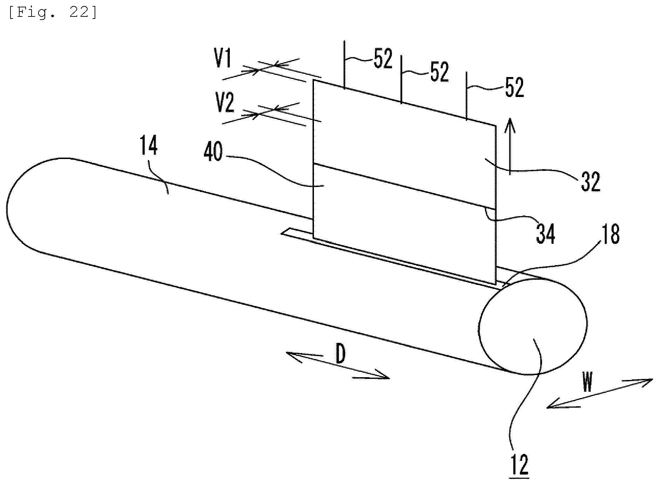

Figs. 21 and 22 illustrate the thin plate-shaped single-crystal production equipment 10 according to the fifth embodiment of the present invention.

Since the thin plate-shaped single-crystal production equipment 10 illustrated in Figs. 21 and 22 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

As illustrated in Figs. 21 and 22, the thin plate-shaped single-crystal production equipment 10 according to the fifth embodiment of the present invention is different from the thin plate-shaped single-crystal production equipment 10 according to the first embodiment in that a raw material lump 12 has a horizontally laid cylindrical shape.

That is, in the thin plate-shaped single-crystal production equipment 10 according to the first embodiment, the rectangular parallelepiped raw material lump 12 is used, but a thin plate-shaped single crystal 40 can be continuously produced even using such a horizontally laid cylindrical raw material lump 12.

Note that, in this case, the horizontally laid cylindrical raw material lump 12 is placed on the placing table 82, a longitudinal direction of the raw material lump 12 (direction D orthogonal to the thickness direction of the raw material lump 12) is aligned with the direction D orthogonal to the thickness direction of the seed single crystal 32, in this state, irradiation of the upper surface 14 of the raw material lump 12 with the laser beam 16a is started, and a seed single crystal 32 is immersed in a melt (molten region) 18 formed at the most protruding portion (top of the circle) of the upper surface 14 of the raw material lump 12 and lifted upward, whereby growth of a thin plate-shaped single crystal 40 can be started.

Since the raw material lump 12 has a circular cross section, the range of the molten region 18 of the raw material lump 12 gradually increases along with growth of the thin plate-shaped single crystal 40, becomes maximum at a time point when a horizontal half (an upper half in the cross section) of the cylindrical raw material lump 12 is melted, and then gradually decreases. When a most part of the raw material lump 12 is melted and solidified, production of the thin plate-shaped single crystal 40 is ended.

Note that an end position of the molten region 18 formed by the irradiation region A of the laser beam 16a on the upper surface 14 of the raw material lump 12 in the thickness direction W needs to coincide with an end position of the upper surface 14 of the raw material lump 12 in the thickness direction W. In this case, it is only required to set the position of the irradiation region A of the laser beam 16a as in the case of using the raw material lump 12 that is large both in the thickness direction W and the direction D orthogonal to the thickness direction, described in the fourth embodiment.

The horizontally laid cylindrical raw material lump 12 can be formed into two cylindrical raw material lumps 12 by cutting a bent portion of a U-shaped single crystal produced by a Siemens method.

In the cylindrical raw material lump 12, since the size of the upper surface 14 changes from moment to moment, it is preferable to set an irradiation program of the laser beam 16a in advance and to form the melt (molten region) 18 in conjunction with the horizontal direction moving apparatus 72.

### [Sixth embodiment]

Next, a thin plate-shaped single-crystal production equipment 10 according to a sixth embodiment of the present invention will be described.

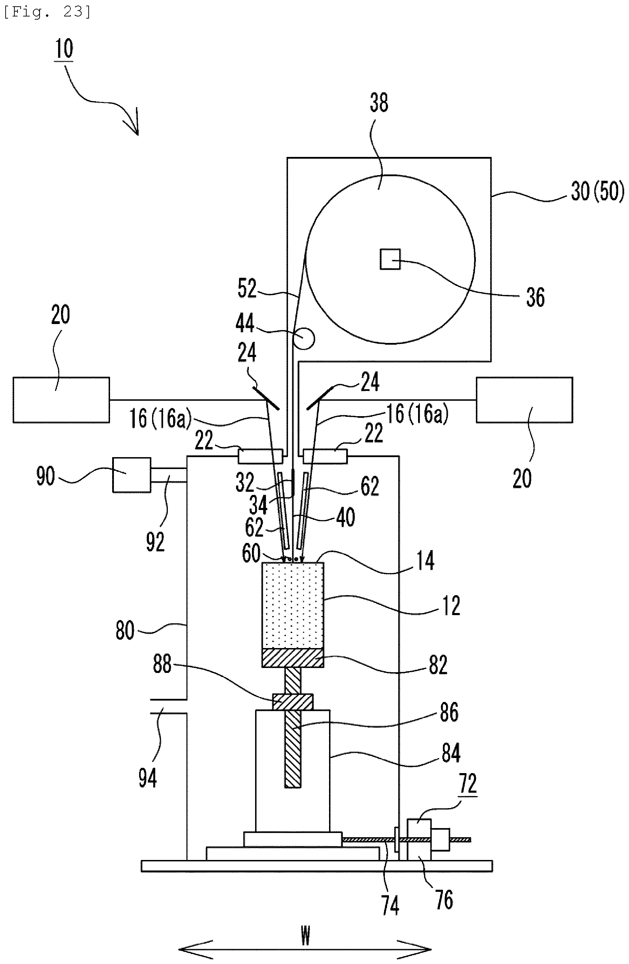

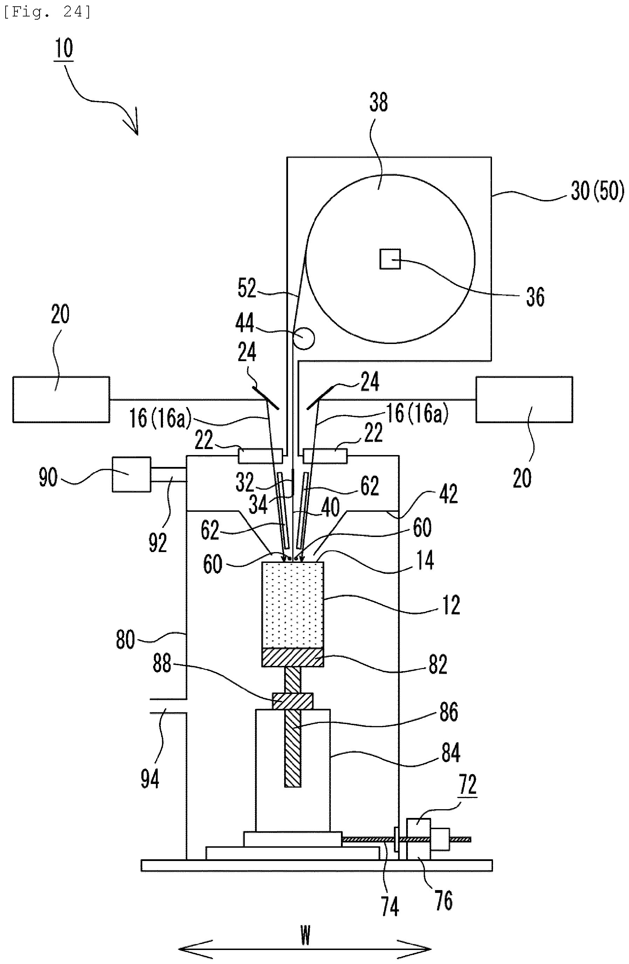

Figs. 23 and 24 illustrate the thin plate-shaped single-crystal production equipment 10 according to the sixth embodiment of the present invention.

Since the thin plate-shaped single-crystal production equipment 10 illustrated in Figs. 23 and 24 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

As illustrated in Figs. 23 and 24, the thin plate-shaped single-crystal production equipment 10 according to the sixth embodiment of the present invention is different from the thin plate-shaped single-crystal production equipment 10 according to the first embodiment in that a chamber 80 includes a gas introduction device 90 that fills the inside of the chamber 80 with an atmosphere gas containing a dopant.

The gas introduction device 90 is disposed on an upper side of the chamber 80, and an atmosphere gas is introduced into the chamber 80 from the gas introduction device 90 through an introduction pipe 92. In addition, a discharge pipe 94 is disposed on a lower side of the chamber 80 such that the atmosphere gas can be discharged from the discharge pipe 94 to the outside of the chamber 80.

As a result, the inside of the chamber 80 can be maintained in a state of being filled with an atmosphere gas suitable for producing a thin plate-shaped single crystal 40, and the high-quality thin plate-shaped single crystal 40 having a uniform dopant concentration can be continuously produced.

Note that it is only required to prepare the atmosphere gas according to characteristics of a material of the thin plate-shaped single crystal 40 to be produced, and for example, when the N-type silicon thin plate-shaped single crystal 40 is produced, a high-purity argon gas containing phosphine (PH₃) at an optimum concentration is preferably introduced into the chamber 80 as the atmosphere gas.

In addition, as illustrated in Fig. 24, for example, a cover member 42 may be disposed below a window 22 for guiding an infrared ray 16 (laser beam 16a) emitted from an infrared ray irradiation apparatus 20 into the chamber 80, and the atmosphere gas may be actively introduced from the gas introduction device 90 into a space divided by the chamber 80 and the cover member 42.

When the atmosphere gas is introduced into the space divided by the chamber 80 and the cover member 42 as described above, it is possible to prevent an evaporated matter generated from the melt 18 from adhering to the window 22, and it is possible to stably and continuously produce the high-quality thin plate-shaped single crystal 40 having a uniform dopant concentration with high yield.

### [Seventh embodiment]

Next, a thin plate-shaped single-crystal production equipment 10 according to a seventh embodiment of the present invention will be described.

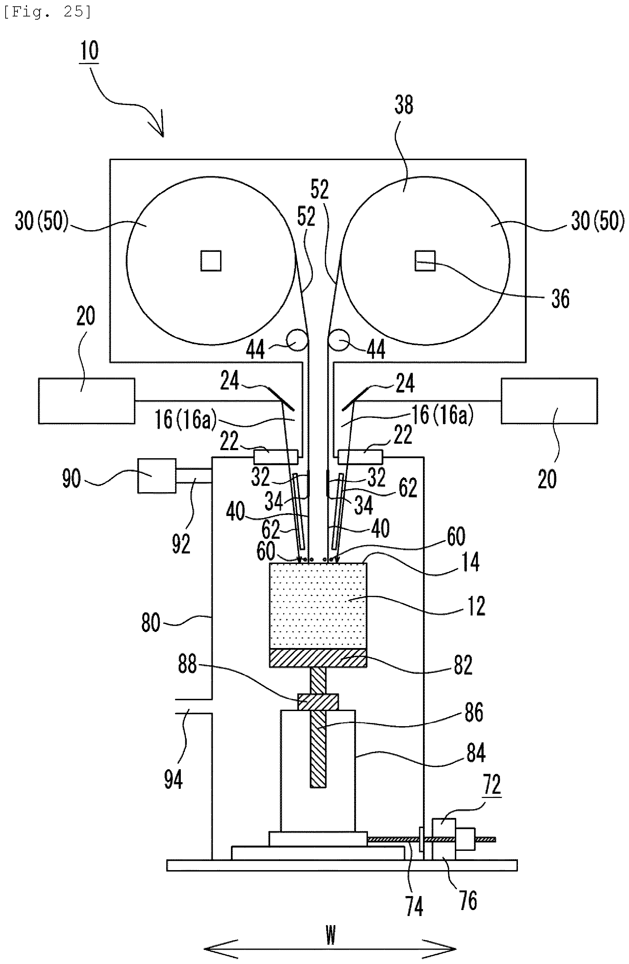

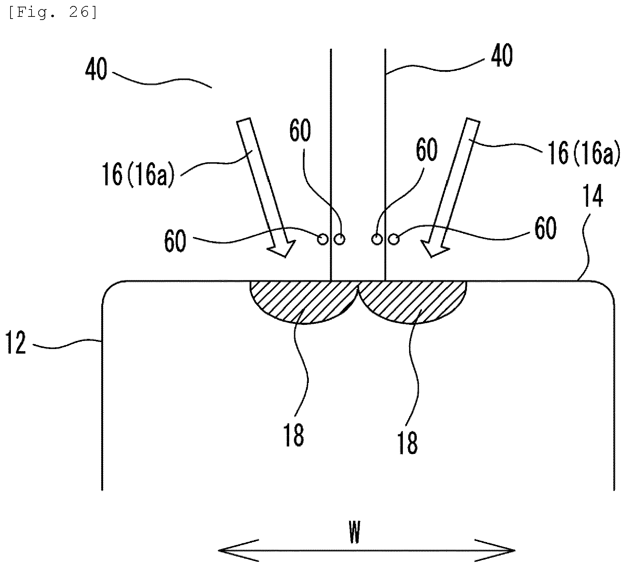

Figs. 25 and 26 illustrate the thin plate-shaped single-crystal production equipment 10 according to the seventh embodiment of the present invention.

Since the thin plate-shaped single-crystal production equipment 10 illustrated in Figs. 25 and 26 basically has the same configuration as the thin plate-shaped single-crystal production equipment 10 of the first embodiment illustrated in Figs. 1 to 11, the same components are denoted by the same reference numerals, detailed description thereof is omitted, and a difference will be described.

As illustrated in Figs. 25 and 26, the thin plate-shaped single-crystal production equipment 10 according to the seventh embodiment of the present invention is different from the thin plate-shaped single-crystal production equipment 10 according to the first embodiment in that a chamber 80 includes a gas introduction device 90 that fills the inside of the chamber 80 with an atmosphere gas containing a dopant and that a plurality of (two in Fig. 25) elevator apparatuses 30 are disposed above a raw material lump 12. Description regarding inclusion of the gas introduction device 90 is similar to that described in the sixth embodiment.

Specifically, the two elevator apparatus 30 (winding apparatus 50) are disposed side by side on the left and right above the chamber 80, and seed single crystals 32 and 32 are immersed in a melt 18 on an upper surface 14 of the raw material lump 12, and are lifted upward by the elevator apparatus 30 and 30 (winding apparatus 50 and 50), whereby thin plate-shaped single crystals 40 and 40 can be produced, respectively.

When the plurality of elevator apparatuses 30 are disposed above the raw material lump 12 as described above, production efficiency of the thin plate-shaped single crystal 40 can be remarkably improved as compared with the case where the number of the elevator apparatus 30 is one.

### <Thin plate-shaped single-crystal production method>

Next, a thin plate-shaped single-crystal production method using the thin plate-shaped single-crystal production equipment 10 of the present invention will be described.

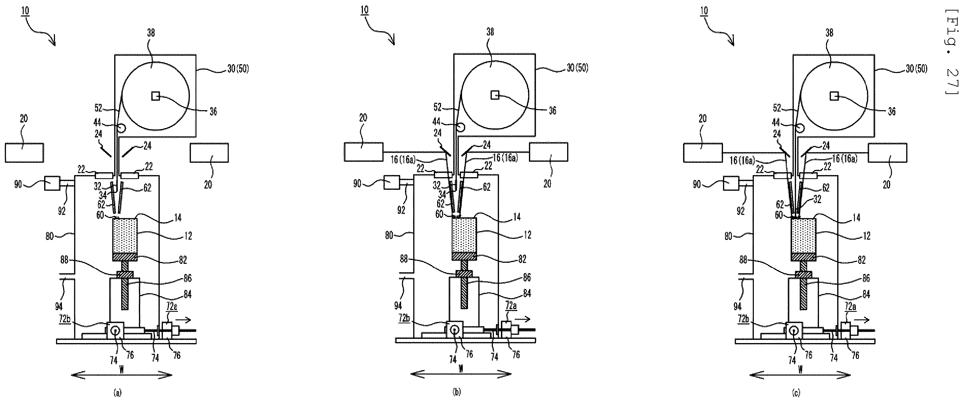

First, as illustrated in Fig. 27(a), the raw material lump 12 is placed on the placing table 82 in the chamber 80, the inside of the chamber 80 is sealed, and the seed single crystal 32 is disposed above the upper surface 14 of the raw material lump 12 such that a longitudinal direction (direction D orthogonal to the thickness direction) of the raw material lump 12 coincides with a longitudinal direction (direction D orthogonal to the thickness direction) of the thin plate-shaped seed single crystal 32. The seed single crystal 32 is suspended from the winding shaft 36 of the winding apparatus 50 via the thin wire 52.

Note that an atmosphere in the chamber 80 is vacuum-evacuated through the discharge pipe 94, and an atmosphere gas matching characteristics of a material of the thin plate-shaped single crystal 40 to be produced is introduced into the chamber 80 through the introduction pipe 92 of the gas introduction device 90.

Next, as illustrated in Fig. 27(b), the vicinity of a corner of the upper surface 14 of the raw material lump 12 is irradiated with an infrared ray 16 (laser beam 16a) via the infrared ray irradiation apparatus 20 to partially melt the upper surface 14.

The irradiation region A of the infrared ray 16 (laser beam 16a) has a hollow quadrangular shape elongated in a horizontal direction, and the laser beam 16a is emitted while being adjusted such that the hollow quadrangular irradiation region A elongated in the horizontal direction is formed on the upper surface 14 of the raw material lump 12.

As a result, the melt 18 (molten region) is formed on the upper surface 14 of the raw material lump 12 by irradiation with the laser beam 16a, and a central portion of the melt 18 (molten region) not irradiated with the laser beam 16a is melted by thermal conduction from the melt 18 in the vicinity of a quadrangular band portion B of the irradiation region A that has been melted first. At the same time, the raw material lump 12 is moved at a predetermined speed in the thickness direction W of the raw material lump 12 and the direction D orthogonal to the thickness direction via the horizontal direction moving apparatus 72a and the horizontal direction moving apparatus 72b such that a corner of the upper surface 14 of the raw material lump 12 is completely covered with the molten region 18.

Next, as illustrated in Figs. 27(c) and 19(a), the lower surface 34 of the thin plate-shaped seed single crystal 32 is immersed in a central portion of the melt 18 (molten region) obtained on the upper surface 14 of the raw material lump 12 via the elevator apparatus 30 (winding apparatus 50), and growth of a single crystal is started from the lower surface 34 of the seed single crystal 32.

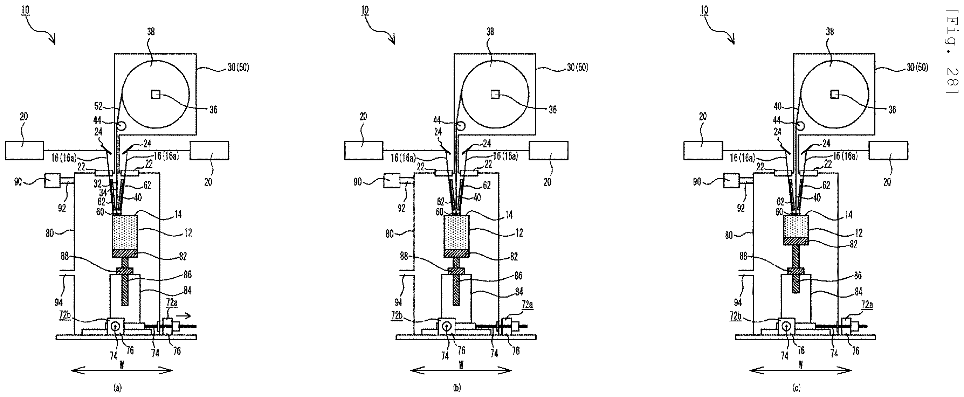

Furthermore, as illustrated in Fig. 28(a), the seed single crystal 32 is lifted upward via the elevator apparatus 30 (winding apparatus 50), and the thin plate-shaped single crystal 40 is continuously produced.

Next, the raw material lump 12 is moved at a predetermined speed in the direction D orthogonal to the thickness direction by the horizontal direction moving apparatus 72b. When the molten region 18 reaches a first end of the raw material lump 12 in the direction D orthogonal to the thickness direction, the raw material lump 12 is then moved by a predetermined length at a predetermined moving speed by the horizontal direction moving apparatus 72a, and movement of the raw material lump 12 toward a second end in the direction D orthogonal to the thickness direction is started again by the horizontal direction moving apparatus 72b, and this is repeated over the entire upper surface 14 of the raw material lump 12 (Figs. 28(b) and 19(b) to 20(c)).

Next, as illustrated in Fig. 28(c), the position of the placing table 82 is moved upward via the position control apparatus 84 along with continuous production of the thin plate-shaped single crystal 40. As a result, even when the position of the melt 18 of the raw material lump 12 is lowered along with lifting, the position of the raw material lump 12 is controlled so as to maintain the initial position, and the liquid surface position of the melt 18 is the same at all times.

Here, in a case where the laser beam 16a is emitted to the upper surface 14 of the raw material lump 12 from directly above the raw material lump 12 perpendicularly as in the thin plate-shaped single-crystal production equipment 10 illustrated in Figs. 4 and 6, the temperature of the melt 18 does not change even when the position of the upper surface 14 of the raw material lump 12 changes, and thus, the position of the upper surface 14 of the raw material lump 12 does not have to be controlled to a fixed position.

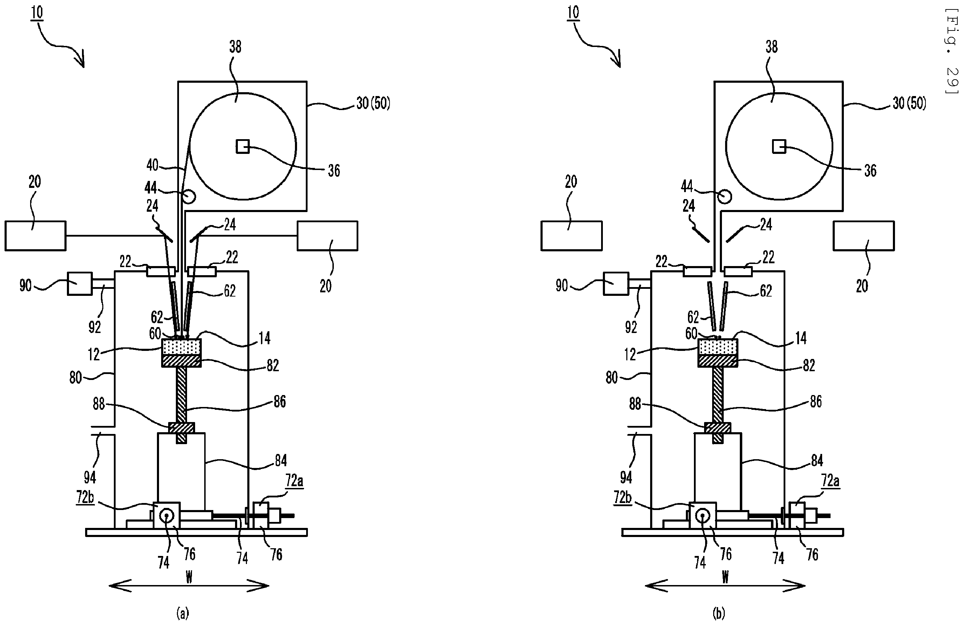

Next, as illustrated in Fig. 29(a), the irradiation amount of the infrared ray 16 (laser beam 16a) by the infrared ray irradiation apparatus 20 is increased to raise the temperature of the melt 18, finally, as illustrated in Fig. 29(b), the thin plate-shaped single crystal 40 is separated from the melt 18, winding of the thin plate-shaped single crystal 40 continuously produced by the elevator apparatus 30 (winding apparatus 50) is ended, and irradiation with the infrared ray 16 (laser beam 16a) by the infrared ray irradiation apparatus 20 is ended. As a result, production of the thin plate-shaped single crystal 40 is completed.

### Examples

### [Example 1]

The N-type silicon thin plate-shaped single crystal 40 containing phosphorus was produced using the thin plate-shaped single-crystal production equipment 10 of the present invention.

Note that as the raw material lump 12, a rectangular parallelepiped raw material lump 12 having a width of 400 mm, a thickness of 500 mm, and a height of 500 mm was used.

Meanwhile, as the thin plate-shaped seed single crystal 32, a silicon seed single crystal 32 having a (111) plane and having a width of 350 mm, a thickness of 0.3 mm, and a height of 100 mm was used. Silicon has a property that a flat surface called a facet is likely to appear in the (111) plane direction, and this flat surface was used as a plate surface of the seed single crystal 32. The seed single crystal 32 was attached to the winding shaft 36 of the winding apparatus 50 via the three thin wires 52 in advance.

First, the raw material lump 12 was placed on the placing table 82 in the chamber 80, the chamber 80 was closed, and an internal atmosphere was brought into a vacuum state.

Next, an atmosphere gas was introduced into the chamber 80. As the atmosphere gas, a high-purity argon gas was used, and a gas containing a necessary amount of phosphine (PH₃) gas was used in order to add phosphorus.

The upper surface 14 of the raw material lump 12 was irradiated with laser beams 16a each having a rectangular cross section with a width of 6 mm and a length of 382 mm from the left and right at an inclination angle of 80 degrees from the horizontal direction. The laser beam 16a on one side was emitted to a position separated by 3 mm from an end of the raw material lump 12 on one side in the thickness direction W, and the laser beam 16a on the other side was emitted to a position separated by 6 mm from the position irradiated with the laser beam 16a on one side.

Furthermore, at the same time, both ends of the raw material lump 12 in the direction D orthogonal to the thickness direction were each irradiated with the laser beam 16a having a rectangular cross section with a width of 6 mm and a length of 18 mm while the irradiation positions were separated by 3 mm from the both ends, respectively, as a short side portion of the quadrangular band portion B of the irradiation region A of the laser beam 16a at an inclination angle of 80 degrees from the horizontal direction.

The shape of the irradiation region A of the laser beam 16a is a hollow quadrangular shape elongated in the horizontal direction as a whole by the four laser beams 16a emitted from the four infrared ray irradiation apparatus 20. As a result, the quadrangular melt 18 (molten region) was formed on the upper surface 14 of the raw material lump 12.

At the same time, the raw material lump 12 was started to move horizontally at a moving speed of 1 mm/min toward a first end in the thickness direction W of the raw material lump 12, when the molten region 18 reached the first end, the moving direction of the raw material lump 12 was reversed, the raw material lump 12 was moved similarly at a speed of 1 mm/min toward a second end in the opposite direction, and this was repeated.

The winding shaft 36 of the winding apparatus 50 was rotated, the lower surface 34 of the seed single crystal 32 was immersed in a central portion of the melt 18 melted by the laser beam 16a, the winding shaft 36 was then rotated in the opposite direction while the thin plate-shaped single crystal 40 was grown from the lower surface 34 of the seed single crystal 32, the seed single crystal 32 was lofted upward at a speed of 5 mm/min, and the thin plate-shaped single crystal 40 was continuously wound up in a roll shape around the winding shaft 36 at an upper portion to produce the long thin plate-shaped single crystal 40 having a long length more than 10 m.

Note that the seed single crystal 32 was set on the winding shaft 36 of the winding apparatus 50 with the thin wire 52 made of a carbon fiber having a diameter of about 0.05 mm, and a rotation direction and a rotation speed of the winding shaft 36 were controlled by the rotating apparatus 38 to move the seed single crystal 32 in the vertical direction.

When the seed single crystal 32 was immersed in the central portion of the melt 18 (molten region) on the upper surface 14 of the raw material lump 12, crystallization was immediately started, and it was confirmed that an immersed portion of the seed single crystal 32 was thickened, but the thickened portion was melted and thinned when the seed single crystal 32 was left as it was.

In this state, the seed single crystal 32 was lifted upward, the thickness of the produced thin plate-shaped single crystal 40 was confirmed with a camera, the thickness was controlled to 0.3 mm while a lifting (winding) speed and an irradiation intensity of the laser beam 16a were adjusted, the winding shaft 36 was rotated, and the thin plate-shaped single crystal 40 was continuously wound around the winding shaft 36. Note that, during this time, operation was continuously performed in which the raw material lump 12 was continuously moved at a speed of 1 mm/min, and when the melt 18 (molten region) reached a first end of the raw material lump 12 in the thickness direction W, the moving direction of the raw material lump 12 was reversed, and the raw material lump 12 was moved toward a second end.

Note that it was confirmed that when the lifting (winding) speed of the seed single crystal 32 was decreased, the thickness of the thin plate-shaped single crystal 40 was increased, and when the lifting (winding) speed was increased, the thickness of the thin plate-shaped single crystal 40 was reduced. The temperature of the melt 18 was adjusted such that the thin plate-shaped single crystal 40 having a thickness of 0.3 mm was continuously lift at a speed of 30 mm per minute.

Here, since the liquid surface position of the melt 18 of the raw material lump 12 is lowered along with lifting of the thin plate-shaped single crystal 40, the position of the placing table 82 on which the raw material lump 12 is placed is controlled to a predetermined position via the position control apparatus 84 so as to maintain the initial position such that the liquid surface position of the melt 18 of the raw material lump 12 is the same position as the initial position at all times.

The thus-produced thin plate-shaped single crystal 40 having a long length of more than 10 m, a thickness of 0.3 mm, and a width of 374 to 378 mm was confirmed using secondary ion mass spectrometry (SIMS).

As a result, it was confirmed that, in the thin plate-shaped single crystal 40, a concentration of phosphorus as a dopant was an optimum composition and uniform, and the thin plate-shaped single crystal 40 had high quality. Superiority of the thin plate-shaped single-crystal production equipment 10 and the thin plate-shaped single-crystal production method of the present invention could be confirmed.

Next, a summary of the thin plate-shaped single-crystal production equipment 10 of the present invention and the thin plate-shaped single-crystal production method using the thin plate-shaped single-crystal production equipment 10 will be described.

The most significant factor for which the thin plate-shaped single crystal 40 can be continuously and stably produced by the thin plate-shaped single-crystal production equipment 10 and the thin plate-shaped single-crystal production method of the present invention is that melting of the raw material lump 12 and single-crystalization from the obtained melt 18 can be each independently and substantially controlled.

In addition, the large raw material lump 12 can be applied using the horizontal direction moving apparatus 72 (72a, 72b) that continuously and reversely moves the raw material lump 12 in the horizontal direction.

That is, heating is required in order to melt the raw material lump 12 to obtain the melt 18, but cooling is required in order to solidify and crystallize the melt 18, and thus both are opposite to each other.

Therefore, in the present invention, a portion to be crystallized (central portion of the melt 18) is not directly irradiated with the laser beam 16a, and a portion other than the portion to be crystallized (a peripheral edge region excluding the central portion of the melt 18) is irradiated with the laser beam 16a to partially melt the upper surface 14 of the raw material lump 12, and heat of the melt 18 is conducted to the portion to be crystallized (central portion) to form the melt 18 (molten region) on the upper surface 14 of the raw material lump 12.

As a result, the temperature of the portion to be crystallized (central portion) is lower than the temperature of the portion melted by irradiation with the laser beam 16a, which facilitates crystallization.

When the seed single crystal 32 is immersed in the central portion of the melt 18, heat of the melt 18 is transferred to the lower surface 34 of the immersed seed single crystal 32. Therefore, the temperature of the melt 18 in contact with the lower surface 34 decreases and crystallization rapidly proceeds. After the raw material lump 12 is left for a while, the amount of heat dissipated through the seed single crystal 32 becomes a steady state, and the portion that has been rapidly solidified until this time is gradually melted due to heat from the surrounding melt 18 and becomes a steady state.

When the seed single crystal 32 is lifted upward (wound) in this state, the seed single crystal 32 moves to a low temperature portion, and therefore crystallization proceeds on the lower surface 34 in contact with the melt 18.

When a lifting speed (winding speed) of the seed single crystal 32 is increased and crystallization cannot catch up with the lifting speed, the thickness of the produced thin plate-shaped single crystal 40 decreases, and when the lifting speed (winding speed) is reduced, crystallization proceeds, and therefore the thickness of the thin plate-shaped single crystal 40 increases.

Therefore, if the temperature of the melt 18 is controlled to be low, crystallization is easy, and the thickness of the thin plate-shaped single crystal 40 increases. Therefore, the thin plate-shaped single crystal 40 having a predetermined thickness can be continuously produced even when the lifting speed (winding speed) is increased.

Note that when the lifting speed (winding speed) of the seed single crystal 32 is increased, production efficiency of the thin plate-shaped single crystal 40 can be increased, but when the lifting speed is too fast, a possibility that cell growth occurs is increased. When cell growth occurs, a concentration of phosphorus as a dopant largely changes locally, and characteristics as a single crystal deteriorate. Therefore, it is important to continuously produce the thin plate-shaped single crystal 40 by increasing the lifting speed (winding speed) as much as possible while suppressing occurrence of cell growth.

Furthermore, according to the present invention, it has become possible for the first time to produce the high-quality thin plate-shaped single crystal 40 having a uniform composition even of a so-called incongruent melting substance such as a decomposition melting substance or a solid solution single crystal. It has been considered that the thin plate-shaped single crystal 40 having a uniform composition of such an incongruent melting substance cannot be produced by a conventional production method.

That is, in order to produce a uniform composition single crystal of the incongruent melting substance by a so-called "melt method" in which a raw material is melted to form a melt and the melt is solidified to produce a single crystal, there is no method in principle other than application of a so-called "solvent transfer method" in which a raw material lump having a target composition is produced, and using a solvent having a solvent composition that coexists in equilibrium with a target composition substance, dissolution of the raw material lump and precipitation of the single crystal from the solvent are caused to proceed simultaneously.

In the present invention, a required amount of a solvent phase component is disposed on the upper surface 14 of the raw material lump 12, and then the solvent phase component is melted by being irradiated with the infrared ray 16 to form a solvent portion. Then, the solvent portion is moved in the horizontal direction, and supply of a new raw material to the solvent portion, production of the thin plate-shaped single crystal 40 from the solvent portion, and solidification of the solvent portion are caused to proceed simultaneously, thereby making it possible to produce the thin plate-shaped single crystal 40 having a uniform composition by applying the "solvent transfer method".

Note that in a case of N-type silicon, a predetermined amount of phosphorus is added as a dopant, but phosphorus is evaporated from the melt 18, and the concentration of phosphorus in the melt 18 decreases with time. Therefore, phosphine (PH₃) was added to an atmosphere to produce (grow) the thin plate-shaped single crystal 40.

In this case, phosphine (PH₃) reacts with the silicon melt to dissolve phosphorus into the melt. There is a concentration difference between the concentration of phosphorus in the melt and the concentration of phosphorus in the solidified thin plate-shaped single crystal 40 according to a concentration ratio defined by a distribution coefficient. When the concentration of phosphorus in the melt is kept constant at a predetermined concentration, the concentration of phosphorus in the thin plate-shaped single crystal 40 is also kept constant.

The concentration of phosphorus in the melt was set such that the concentration of phosphorus in the thin plate-shaped single crystal 40 was optimal, and the concentration of phosphine (PH₃) in the atmosphere was set such that the concentration of phosphorus was maintained.

Hereinabove, the thin plate-shaped single-crystal production equipment 10 of the present invention and the thin plate-shaped single-crystal production method using the thin plate-shaped single-crystal production equipment 10 have been described, but the present invention is not limited to the above embodiment.

For example, in the thin plate-shaped single-crystal production equipment 10 described above, the first to seventh embodiments have been described separately, but these embodiments may be appropriately combined to form the thin plate-shaped single-crystal production equipment 10 of the present invention.

Furthermore, in the thin plate-shaped single-crystal production equipment 10 described above, the case where the infrared ray irradiation apparatus 20 are disposed in four sides that are upper, lower, left, and right sides (for example, every 90 degrees) with the raw material lump 12 as a center in a top view such that the hollow quadrangular irradiation region A can be formed by the laser beams 16a emitted from the infrared ray irradiation apparatus 20 is taken as an example. However, the present invention is not limited thereto, and the laser beam 16a emitted from one infrared ray irradiation apparatus 20 may be divided such that the laser beams 16a are emitted to the raw material lump 12 from four sides.

Furthermore, the number of the infrared ray irradiation apparatus 20 is not limited to four (every 90 degrees), and may be two (every 180 degrees), for example. The number of the infrared ray irradiation apparatus 20 only needs to be determined in consideration of, for example, the size of the hollow quadrangular irradiation region A of the laser beam 16a or an output intensity of the infrared ray irradiation apparatus 20.

In addition, the cross-sectional shape of the laser beam 16a emitted from one infrared ray irradiation apparatus 20 is not limited to a rectangle as long as the laser beam 16a can be emitted so as to form the hollow quadrangular irradiation region A that is elongated in the horizontal direction and coincides with a peripheral edge region of the upper surface 14 of the raw material lump 12 excluding a central portion.

That is, the laser beam 16a having a U-shaped cross section may be emitted to the upper surface 14 of the raw material lump 12 from each of the left and right, and the irradiation region A having a hollow quadrangular cross-sectional shape elongated in the horizontal direction may be formed by the two laser beams 16a and 16a each having a U-shaped cross section.

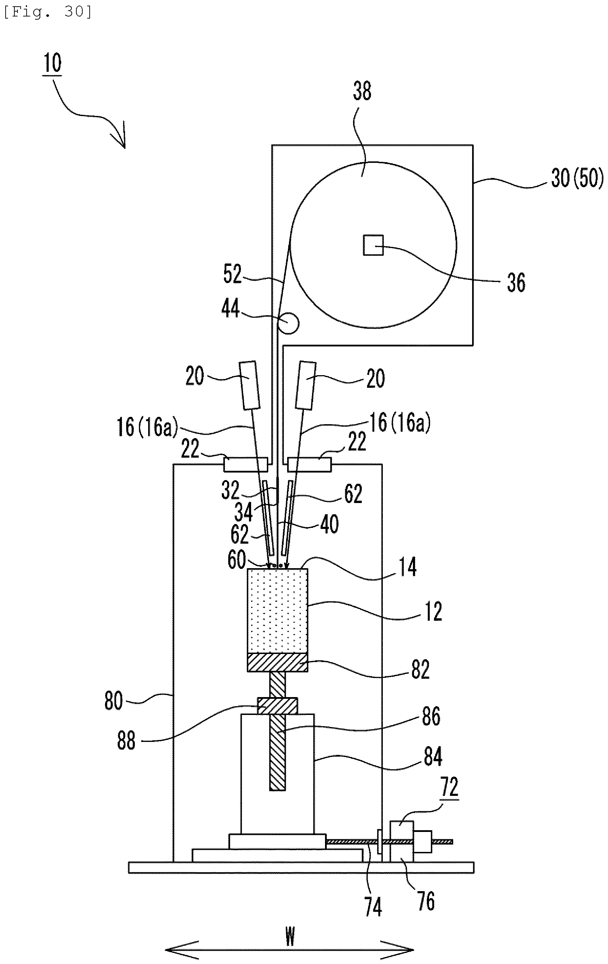

In addition, in the thin plate-shaped single-crystal production equipment 10 described above, the infrared ray 16 (laser beam 16a) emitted from the infrared ray irradiation apparatus 20 is introduced into the chamber 80 via the reflector 24. However, as illustrated in Fig. 30, the infrared ray 16 may be directly introduced into the chamber 80 without passing through the reflector 24. Whether or not the infrared ray 16 needs to pass through the reflector 24 only needs to be appropriately determined in view of, for example, the configuration and size of the thin plate-shaped single-crystal production equipment 10.

Furthermore, the thickness of the thin plate-shaped single crystal 40 to be produced is described as a thickness of about 30 um to 500 µm, but the thin plate-shaped single crystal 40 can be produced in principle even if the thickness is, for example, 5000 um or more, and the thickness is not limited to the above range.

In addition, the thickness of the seed single crystal 32 to be immersed in the melt 18 is described as, for example, a thickness of about 300 um to 500 µm, but even if the thickness is out of this range, the thin plate-shaped single crystal 40 can be produced in principle, and the thickness is not limited to the above range.

Furthermore, in a case where the N-type silicon thin plate-shaped single crystal 40 containing phosphorus is produced, phosphine (PH₃) is added in advance into the atmosphere as described above, and the phosphine (PH₃) and a silicon melt react with each other to dissolve phosphorus in the melt, whereby the N-type silicon thin plate-shaped single crystal 40 containing phosphorus is produced. However, the present invention is not limited thereto, and the raw material lump 12 initially containing a dopant (phosphorus) in an amount obtained by adding the amount of dopant (phosphorus) lost by evaporation to the amount of dopant (phosphorus) originally required may be produced.

As described above, the thin plate-shaped single-crystal production equipment 10 and the thin plate-shaped single-crystal production method of the present invention can be variously changed without departing from the object of the present invention.

### Reference Signs List

- 10: Thin plate-shaped single-crystal production equipment
- 12: Raw material lump
- 14: Upper surface
- 16: Infrared ray
- 16a: Laser beam
- 18: Melt (molten region)
- 20: Infrared ray irradiation apparatus
- 22: Window
- 24: Reflector
- 30: Elevator apparatus
- 32: Seed single crystal
- 34: Lower surface
- 36: Winding shaft
- 38: Rotating apparatus
- 40: Thin plate-shaped single crystal
- 42: Cover member
- 44: Rotating roller
- 50: Winding apparatus
- 52: Thin wire
- 60: Shake preventing member
- 62: Shielding member
- 64: Auxiliary heating member
- 66: Heat insulating material
- 72: Horizontal direction moving apparatus
- 72a: Horizontal direction moving apparatus
- 72b: Horizontal direction moving apparatus
- 74: Drive shaft
- 76: Driving apparatus
- 80: Chamber
- 82: Placing table
- 84: Position control apparatus
- 86: Drive shaft
- 88: Driving apparatus
- 90: Gas introduction device
- 92: Introduction pipe
- 94: Discharge pipe
- A: Irradiation region
- B: Quadrangular band portion
- C: Central portion
- D: Direction orthogonal to thickness direction of raw material lump
- E: Width of laser beam
- F: Distance between laser beam and laser beam
- T1: Size of lower surface of seed single crystal in longitudinal direction (direction orthogonal to thickness direction)
- T2: Size of upper surface of raw material lump in direction orthogonal to thickness direction
- V1: Thickness of portion of seed single crystal to which thin wire is attached
- V2: Thickness of seed single crystal
- W: Thickness direction of raw material lump

## Claims

1. A thin plate-shaped single-crystal production equipment comprising:
an infrared ray irradiation apparatus that irradiates an upper surface of a raw material lump for producing a thin plate-shaped single crystal with an infrared ray to melt a surface of the upper surface of the raw material lump;
an elevator apparatus that immerses a lower surface of a thin plate-shaped seed single crystal in a melt melted by the infrared ray irradiation apparatus and obtained on the surface of the upper surface of the raw material lump, and lifts the seed single crystal upward from an immersed state; and
a horizontal direction moving apparatus that moves the raw material lump in a horizontal direction, wherein
the thin plate-shaped single-crystal production equipment is configured such that, by immersing the lower surface of the seed single crystal in the melt obtained on the surface of the upper surface of the raw material lump by the infrared ray irradiation apparatus via the elevator apparatus, growth of a single crystal is started from the lower surface of the immersed seed single crystal, and
furthermore, by moving the raw material lump in the horizontal direction by the horizontal direction moving apparatus simultaneously with lifting the seed single crystal upward via the elevator apparatus, a thin plate-shaped single crystal is continuously produced while a molten region of the upper surface of the raw material lump is moved in the horizontal direction.

2. The thin plate-shaped single-crystal production equipment according to claim 1, wherein the infrared ray emitted from the infrared ray irradiation apparatus is a laser beam.

3. The thin plate-shaped single-crystal production equipment according to claim 2, wherein an irradiation region of the laser beam has a hollow quadrangular shape elongated in a horizontal direction orthogonal to a thickness direction of the raw material lump.

4. The thin plate-shaped single-crystal production equipment according to claim 3, comprising:
a placing table on which the raw material lump is placed; and
a position control apparatus that performs position control such that a position of the placing table in a vertical direction is a predetermined position.

5. The thin plate-shaped single-crystal production equipment according to claim 4, wherein
the horizontal direction moving apparatus includes:
a drive shaft disposed on a bottom side of the position control apparatus; and
a driving apparatus that drives the drive shaft, and
the horizontal direction moving apparatus is configured to move the placing table and the position control apparatus in a horizontal direction which is the thickness direction of the raw material lump by driving the drive shaft via the driving apparatus.

6. The thin plate-shaped single-crystal production equipment according to claim 5, wherein
in a case where the horizontal direction moving apparatus is configured to
move the placing table and the position control apparatus in a horizontal direction which is the thickness direction of the raw material lump,
positions of both ends of an upper surface of the raw material lump in a horizontal direction orthogonal to the thickness direction of the raw material lump substantially coincide with positions of both ends of the hollow quadrangular shape in the horizontal direction orthogonal to the thickness direction of the raw material lump, and
a size of the irradiation region of the laser beam is set such that a length of the hollow quadrangular shape in the horizontal direction orthogonal to the thickness direction of the raw material lump is slightly smaller than a length of the upper surface of the raw material lump in the horizontal direction orthogonal to the thickness direction of the raw material lump.

7. The thin plate-shaped single-crystal production equipment according to claim 4, wherein
the horizontal direction moving apparatus includes:
a drive shaft disposed on a bottom side of the position control apparatus; and
a driving apparatus that drives the drive shaft, and
the horizontal direction moving apparatus is configured to move the placing table and the position control apparatus in a horizontal direction which is a direction orthogonal to the thickness direction of the raw material lump by driving the drive shaft via the driving apparatus.

8. The thin plate-shaped single-crystal production equipment according to claim 7, wherein
in a case where the horizontal direction moving apparatus is configured to
move the placing table and the position control apparatus in a horizontal direction which is a direction orthogonal to the thickness direction of the raw material lump,
positions of both ends of an upper surface of the raw material lump in a horizontal direction which is the thickness direction of the raw material lump substantially coincide with positions of both ends of the hollow quadrangular shape in the horizontal direction which is the thickness direction of the raw material lump, and
a size of the irradiation region of the laser beam is set such that a length of the hollow quadrangular shape in the horizontal direction which is the thickness direction of the raw material lump is slightly smaller than a length of the upper surface of the raw material lump in the horizontal direction which is the thickness direction of the raw material lump.

9. The thin plate-shaped single-crystal production equipment according to claim 4, wherein
the horizontal direction moving apparatus includes:
a drive shaft disposed on a bottom side of the position control apparatus; and
a driving apparatus that drives the drive shaft, and
the horizontal direction moving apparatus is configured to move the placing table and the position control apparatus in a horizontal direction which is the thickness direction of the raw material lump and/or in a horizontal direction which is a direction orthogonal to the thickness direction of the raw material lump by driving the drive shaft via the driving apparatus.

10. The thin plate-shaped single-crystal production equipment according to any one of claims 4 to 9, wherein
a moving speed of the placing table and the position control apparatus in the horizontal direction is
within a range of 0.005 mm/min to 100 mm/min.

11. The thin plate-shaped single-crystal production equipment according to any one of claims 4 to 10, wherein
the horizontal direction moving apparatus is
a linear actuator.

12. The thin plate-shaped single-crystal production equipment according to any one of claims 1 to 11, wherein
the elevator apparatus is
a winding apparatus that continuously winds the produced thin plate-shaped single crystal into a roll shape,
the winding apparatus includes:
a winding shaft that continuously winds the thin plate-shaped single crystal; and
a rotating apparatus that rotates the winding shaft, and
the winding apparatus is configured such that the seed single crystal is suspended from the winding shaft via a plurality of thin wires.

13. The thin plate-shaped single-crystal production equipment according to claim 12, wherein
a winding speed of the thin plate-shaped single crystal by the winding apparatus is
within a range of 0.005 mm/min to 100 mm/min.

14. The thin plate-shaped single-crystal production equipment according to claim 12 or 13, wherein
in the seed single crystal,
a thickness of a portion to which the thin wires are attached is
equal to or less than a thickness of the thin plate-shaped single crystal to be produced.

15. The thin plate-shaped single-crystal production equipment according to any one of claims 1 to 14, wherein when a material of the raw material lump is silicon, a thickness of the thin plate-shaped single crystal is within a range of 30 um to 500 um.

16. The thin plate-shaped single-crystal production equipment according to any one of claims 4 to 11, wherein an auxiliary heating member that heats the raw material lump in advance is disposed around the raw material lump.

17. The thin plate-shaped single-crystal production equipment according to claim 16, wherein a heat insulating material is further disposed outside the auxiliary heating member.

18. The thin plate-shaped single-crystal production equipment according to any one of claims 1 to 17, wherein
on the upper surface of the raw material lump,
a required amount of a composition of a liquid phase that coexists in equilibrium with a composition of the thin plate-shaped single crystal to be produced is first disposed.

19. A thin plate-shaped single-crystal production method comprising at least:
a melting step of irradiating an upper surface of a raw material lump for producing a thin plate-shaped single crystal with an infrared ray via an infrared ray irradiation apparatus to melt a surface of the upper surface of the raw material lump;
a growing step of immersing a lower surface of a thin plate-shaped seed single crystal via an elevator apparatus in a melt obtained on the surface of the upper surface of the raw material lump in the melting step to start growth of a single crystal from the lower surface of the seed single crystal; and
a continuous production step of continuously producing a thin plate-shaped single crystal while a molten region of the upper surface of the raw material lump is moved in a horizontal direction by moving the raw material lump in the horizontal direction via a horizontal direction moving apparatus simultaneously with lifting the seed single crystal in which growth of the single crystal has been started in the growing step upward.

20. The thin plate-shaped single-crystal production method according to claim 19, wherein
in the melting step,
the infrared ray emitted from the infrared ray irradiation apparatus is a laser beam.

21. The thin plate-shaped single-crystal production method according to claim 20, wherein
in the continuous production step,
the raw material lump is moved in a horizontal direction which is a thickness direction of the raw material lump via the horizontal direction moving apparatus.

22. The thin plate-shaped single-crystal production method according to claim 21, wherein
in the continuous production step,
when the molten region reaches a first end of the upper surface of the raw material lump in the thickness direction of the raw material lump, the molten region is then moved toward a second end in the thickness direction of the raw material lump, which is the opposite side, and this is continuously repeated.

23. The thin plate-shaped single-crystal production method according to claim 21 or 22, wherein
in the melting step,
an irradiation region of the laser beam has a hollow quadrangular shape elongated in a horizontal direction orthogonal to the thickness direction of the raw material lump,
positions of both ends of an upper surface of the raw material lump in the horizontal direction orthogonal to the thickness direction of the raw material lump substantially coincide with positions of both ends of the hollow quadrangular shape in the horizontal direction orthogonal to the thickness direction of the raw material lump, and
a size of the irradiation region of the laser beam is set such that a length of the hollow quadrangular shape in the horizontal direction orthogonal to the thickness direction of the raw material lump is slightly smaller than a length of the upper surface of the raw material lump in the horizontal direction orthogonal to the thickness direction of the raw material lump.

24. The thin plate-shaped single-crystal production method according to claim 20, wherein
in the continuous production step,
the raw material lump is moved in a horizontal direction which is a direction orthogonal to the thickness direction of the raw material lump via the horizontal direction moving apparatus.

25. The thin plate-shaped single-crystal production method according to claim 24, wherein
in the continuous production step,
when the molten region reaches a first end of the upper surface of the raw material lump in a direction orthogonal to the thickness direction of the raw material lump, the molten region is then moved toward a second end in the direction orthogonal to the thickness direction of the raw material lump, which is the opposite side, and this is continuously repeated.

26. The thin plate-shaped single-crystal production method according to claim 24 or 25, wherein
in the melting step,
an irradiation region of the laser beam has a hollow quadrangular shape elongated in a horizontal direction orthogonal to the thickness direction of the raw material lump,
positions of both ends of an upper surface of the raw material lump in the thickness direction of the raw material lump substantially coincide with positions of both ends of the hollow quadrangular shape in the thickness direction of the raw material lump, and
a size of the irradiation region of the laser beam is set such that a length of the hollow quadrangular shape in a horizontal direction which is the thickness direction of the raw material lump is slightly smaller than a length of the upper surface of the raw material lump in the horizontal direction which is the thickness direction of the raw material lump.

27. The thin plate-shaped single-crystal production method according to claim 20, wherein
in the continuous production step,
the raw material lump is moved in a horizontal direction which is the thickness direction of the raw material lump and in a horizontal direction which is a direction orthogonal to the thickness direction of the raw material lump via the horizontal direction moving apparatus.

28. The thin plate-shaped single-crystal production method according to claim 27, wherein
in the continuous production step,
when the molten region reaches a first end of the upper surface of the raw material lump in a horizontal direction orthogonal to the thickness direction of the raw material lump, the molten region is moved by a predetermined length in the thickness direction of the raw material lump, and the molten region is then moved toward a second end in the horizontal direction orthogonal to the thickness direction of the raw material lump, which is the opposite side, and
next, the molten region is moved again toward the first end in the horizontal direction orthogonal to the thickness direction of the raw material lump, and this is continuously performed on the entire upper surface of the raw material lump.

29. The thin plate-shaped single-crystal production method according to claim 27 or 28, wherein
in the melting step,
an irradiation region of the laser beam has a hollow quadrangular shape elongated in a horizontal direction orthogonal to the thickness direction of the raw material lump.

30. The thin plate-shaped single-crystal production method according to any one of claims 19 to 29, wherein
in the continuous production step,
a moving speed when the raw material lump is moved in the horizontal direction via the horizontal direction moving apparatus is within a range of 0.005 mm/min to 100 mm/min.

31. The thin plate-shaped single-crystal production method according to any one of claims 19 to 30, further comprising
a winding step of winding the continuously produced thin plate-shaped single crystal into a roll shape
after the continuous production step.

32. The thin plate-shaped single-crystal production method according to claim 31, wherein
in the winding step,
a winding speed of the thin plate-shaped single crystal is within a range of 0.005 mm/min to 100 mm/min.

33. The thin plate-shaped single-crystal production method according to any one of claims 19 to 32, wherein
in the melting step,
when the thin plate-shaped single crystal to be produced is a decomposition melting substance, a required amount of a composition of a liquid phase that coexists in equilibrium with a composition of the decomposition melting substance is first disposed on the upper surface of the raw material lump.

34. The thin plate-shaped single-crystal production method according to any one of claims 19 to 32, wherein
in the melting step,
when the thin plate-shaped single crystal to be produced is a solid solution substance containing a dopant, a required amount of a composition of a liquid phase that coexists in equilibrium with a composition of the solid solution substance is first disposed on the upper surface of the raw material lump.
